(19) Europäisches Patentamt
European Patent Office
Office européen des brevets

(11) **EP 3 726 583 A1**

(12) **EUROPEAN PATENT APPLICATION**
published in accordance with Art. 153(4) EPC

(43) Date of publication:
**21.10.2020 Bulletin 2020/43**

(51) Int Cl.:
**H01L 27/32** (2006.01)

(21) Application number: **18887868.0**

(22) Date of filing: **28.11.2018**

(86) International application number:
**PCT/KR2018/014754**

(87) International publication number:
**WO 2019/117507 (20.06.2019 Gazette 2019/25)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **15.12.2017 KR 20170173196**

(71) Applicant: **Joe, Eur Ho
Changwon-Si Gyeongsangnam-Do 51114 (KR)**

(72) Inventor: **Joe, Eur Ho
Changwon-Si Gyeongsangnam-Do 51114 (KR)**

(74) Representative: **dompatent von Kreisler Selting
Werner -
Partnerschaft von Patent- und Rechtsanwälten
mbB
Deichmannhaus am Dom
Bahnhofsvorplatz 1
50667 Köln (DE)**

(54) **DISPLAY DEVICE HAVING PYRAMID SUBPIXEL ARRAY STRUCTURE**

(57) The present invention relates to a display device having a subpixel array structure. The display device comprises a plurality of unit pixels having a designated subpixel array structure, wherein each of the unit pixels includes at least one red, at least one green, and at least one blue subpixel, and the squared unit pixel includes a first subpixel having a first color and arranged at the center thereof, second subpixels having a second color and arranged at two diagonally opposite corners among four corners thereof, and third subpixels having a third color and arranged at the remaining two diagonally opposite corners among the four corners.

【FIG.3】

**Description**

[Technical Field]

The present invention relates to a display device having a subpixel array structure and to a display device having a pyramid subpixel array structure including a plurality of unit pixels having the same subpixel array structure.

[Background Art]

A cathode ray tube, a liquid crystal display (LCD), an organic light emitting diode (OLED), a plasma display panel (PDP), etc. have been known as display devices for an image implementation.

An active matrix type organic light emitting diode display (AMOLED) includes an organic light emitting diode (hereinafter the OLED) that autonomously emits light, and has advantages of a fast response speed and great emission efficiency, brightness and viewing angle. The OLED displays an image by controlling a current flowing into the OLED using a thin film transistor (hereinafter referred to as a "TFT").

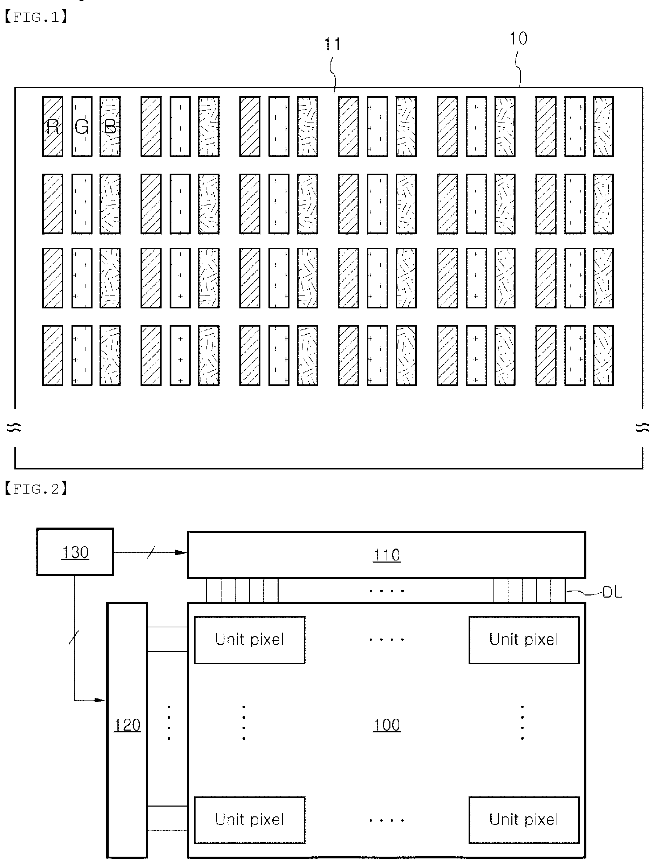

A common OLED includes multiple red subpixels, green subpixels and blue subpixels for a full color implementation. In the OLED, an RGB stripe structure, such as that of FIG. 1, has been known as the array structure of subpixels.

Referring to FIG. 1, each of unit pixels formed in a display panel 10 includes the red subpixel SPR, the green subpixel SPG and the blue subpixel SPB adjacent to each other in parallel. The red, green and blue subpixels SPR, SPG and SPB are arrayed in a stripe form and partitioned by a black region 11. A red light-emitting layer, a green light-emitting layer and a blue light-emitting layer are formed in the OLEDs of the red, green and blue subpixels SPR, SPG and SPB, respectively. The light-emitting layer is deposited for each subpixel through a fine metal mask method using a shadow mask.

Such an FMM process requires a process margin having a given interval between the adjacent red, green and blue subpixels SPR, SPG and SPB. The interval between the subpixels is reduced as resolution of the display panel is increased. Accordingly, in order to secure the process margin, the aperture region of the subpixels is inevitably reduced. If the aperture region is reduced, the aperture ratio and brightness of the entire panel are degraded.

An LCD panel has been most adopted for the display of a cellular phone. In the LCD, unit pixels and R/G/B subpixels are fully arranged in relation to both an X axis and a Y axis. For a display screen, all of global cellulars including the LCD may have different sizes and panel resolution in their detailed configurations, but use almost the same configuration.

Meanwhile, the OLED has long been mentioned, but is limitedly used because it has shorter lifespan than other display devices although the OLED has better characteristics (e.g., a much larger contrast ratio, a thinner thickness, a lighter weight). The lifespan problem of the OLED is related to physical characteristics of materials used in an OLED fabrication process. The organic materials has a disadvantage in that it is relatively less stable than solid semiconductor materials with respect to environmental stress and operative stress, such as heat and an electricity flow.

If an OLED device is configured using a multi-layer stacking method and when the device generates photons that consume electric energy, the layers themselves and boundaries between other layers are damaged by an electron-hole movement, degrading surface quality. The OLED produces brighter light as the device consumes a higher current, and thus the lifespan of the device is degraded more quickly. Such degradation of device performance reduces efficiency for converting consumed electric energy into light energy. As a result, lifespan is ended.

The lifespan of a current OLED device is directly related to the intensity of a current flowing through the OLED device. In other words, when a current flows through a sufficiently wide OLED device region, sufficient long lifespan can be maintained. When a common OLED is fabricated using R/G/B subpixels, subpixel regions having different colors need to be separated at a sufficient space in order to prevent color blurring caused by the leakage current from adjacent subpixels having different colors. In general, a pixel definition layer (PDL), that is, a non-conductive material, is used to divide the subpixel regions and to prevent an interaction between them. A pixel definition gap (PDG) may be used for isolation purposes, and covers the space between subpixels having different colors.

Many other types of OLED configurations are developed and designed to achieve a high aperture ratio by OLED display manufacturers. Some of them are implemented in actual cellular products. Pixel structures having various forms of arrays, such as "PenTile", "S-Stripe", "Diamond PenTile", and "super AMOLED Plus", have been developed and used as the pixel structures of the OLED.

In today's OLED products, a minimum width/length/space of the PDL or PDG needs to be significantly great in a fabrication process compared to the unit pixel pitch of a display panel. This is one of major factors that hinder an increase in the aperture ratio. All OLED panel fabrications are focused on a method for minimizing the width/length/space of the PDL/PDG from a fabrication viewpoint. An optimized pixel configuration having a maximum aperture ratio and minimum visual artifacts on a display screen needs to be developed.

[Prior Art Document] (Patent Document 1) Korean Patent Application Publication No. 10-2016-0126567 DISPLAY DEVICE HAVING SUB-PIXEL ARRAY STRUCTURE (LG Electronics Co., Ltd.) November 02, 2016

[Disclosure]

[Technical Problem]

Accordingly, an object of the present invention is to provide a display device having a pyramid subpixel array structure, which has a maximum aperture ratio and can also minimize visual artifacts in the display device.

[Technical Solution]

A display device having a subpixel array structure for achieving the object includes a plurality of unit pixels each having a designated subpixel array structure, wherein each of the unit pixels includes at least one red subpixel, at least one green subpixel and at least one blue subpixel, a first subpixel having a first color is positioned at the center of each of the unit pixels having a square form, second subpixels having a second color are disposed at two corners diagonal to each other among four corners of each of the unit pixels, and third subpixels having a third color are disposed at the remaining two diagonal corners of the four corners.

Preferably, the second subpixels and the third subpixels are isolated and disposed from a boundary between the unit pixels as much as a designated length.

Preferably, in the display device, at least one subpixel of a first unit pixel and at least one subpixel of a second unit pixel adjacent to the first unit pixel are merged to have a pyramid form.

Preferably, subpixels adjacent to each other, among at least one subpixel of a first unit pixel and at least one subpixel of a second unit pixel adjacent to the first unit pixel, have the same color.

Preferably, subpixels adjacent to each other, among at least one subpixel of a first unit pixel and at least one subpixel of a second unit pixel adjacent to the first unit pixel, are divided by an electrode.

Preferably, the first subpixel is green.

Preferably, the first subpixel has a diamond form.

Preferably, the second subpixel is blue, and the third subpixel is red.

Preferably, the second subpixel or the third subpixel has a triangle form.

In another aspect, a display device having a subpixel array structure according to the present invention for achieving the object includes a plurality of unit pixels each having a designated subpixel array structure, wherein each of the unit pixels includes at least one red subpixel, at least one green subpixel and at least one blue subpixel, first subpixels having a first color are disposed at two corners diagonal to each other among four corners of each of the unit pixels, and a second subpixel having a second color and a third subpixel having a third color are disposed at the remaining two diagonal corners of the four corners.

Preferably, each of the subpixels disposed at the corners is isolated and disposed from a boundary between the unit pixels as much as a designated length.

Preferably, subpixels adjacent to each other, among at least one subpixel of a first unit pixel and at least one subpixel of a second unit pixel adjacent to the first unit pixel, have the same color.

Preferably, subpixels adjacent to each other, among at least one subpixel of a first unit pixel and at least one subpixel of a second unit pixel adjacent to the first unit pixel, are divided by an electrode.

Preferably, the first subpixel is green.

Preferably, each of the subpixels has a quadrangle form.

Preferably, the second subpixel is blue, and the third subpixel is red.

In another aspect, a display device having a subpixel array structure according to the present invention for achieving the object includes a plurality of unit pixels each having a designated subpixel array structure, wherein each of the unit pixels includes at least one red subpixel, at least one green subpixel and at least one blue subpixel, a first subpixel having a first color is positioned at a first corner of four corners of each of the unit pixels, a second subpixel having a second color is positioned at a second corner of the four corners, and third subpixels having a third color are positioned at third corners of the four corners, and each of the subpixels disposed at the corners is isolated and disposed from a boundary between the unit pixels as much as a designated length.

Preferably, subpixels adjacent to each other, among at least one subpixel of a first unit pixel and at least one subpixel of a second unit pixel adjacent to the first unit pixel, have the same color.

Preferably, subpixels adjacent to each other, among at least one subpixel of a first unit pixel and at least one subpixel of a second unit pixel adjacent to the first unit pixel, are divided by an electrode.

Preferably, each of the subpixels has a triangle or quadrangle form.

[Advantageous Effects]

According to the present invention, some of or all subpixels having the same color in adjacent locations in a pyramid pixel structure can be separated and divided by separating the electrode of an OLED element not a PDL gap.

Subpixels divided by separating the electrode can be fabricated through only one deposition process using one FMM. Accordingly, there are advantages in that an additional process step, such as a dual deposition scheme, does not need to be performed and an additional equipment or material, such as a dual FMM set, is not necessary.

[Description of Drawings]

FIG. 1 is a diagram illustrating a conventional subpixel array structure of an RGB stripe method.

FIG. 2 is a diagram schematically illustrating a display device according to an embodiment of the present invention.

FIG. 3 is a diagram illustrating the subpixel array structure of each unit pixel in the display device according to a first embodiment of the present invention.

FIG. 4 is a diagram illustrating a 2×2 pixel array implemented in a subpixel array structure, such as FIG. 3.

FIG. 5 is a diagram illustrating the vertical structure of a pyramid pixel according to a first embodiment of the present invention.

FIGS. 6a and 6b are diagrams illustrating a process of fabricating a pyramid pixel according to an embodiment of the present invention.

FIGS. 7a and 7b are diagrams illustrating cross sections of pyramid pixels fabricated according to an embodiment of the present invention.

FIGS. 8a to 8h are diagrams illustrating various forms of subpixel array structures for a unit pixel.

FIG. 9 is a diagram illustrating the structure of image data according to an embodiment of the present invention.

FIG. 10 is a diagram illustrating a 4×4 pyramid pixel array according to an embodiment of the present invention.

FIGS. 11 to 13 are diagrams for describing image artifacts of a pyramid pixel according to an embodiment of the present invention.

FIGS. 14 to 17 are diagrams for describing image artifacts for various types of pixel arrays.

FIGS. 18 to 29 are diagrams illustrating subpixel array structures having modified forms of unit pixels according to various embodiments.

[Best Mode for Invention]

Hereinafter, detailed contents for implementing the present invention are described based on embodiments with reference to the accompanying drawings. The embodiments are described in detail in order for those skilled in the art to readily implement the present invention. It is to be noted that various embodiments of the present invention are different from each other, but do not need to be exclusive. For example, a specific shape, structure, and characteristic described in this specification may be implemented as another embodiment without departing from the spirit and scope of the present invention in relation to an embodiment. It is also to be understood that the position or arrangement of each element within each described embodiment may be changed without departing from the spirit and scope of the present invention. Accordingly, the following detailed description is not intended to have a limited meaning. The range of the present invention is restricted by only the claims along with all ranges equivalent to that written in the claims if it is appropriately described. The same or similar reference numerals are used to denote the same or similar functions throughout the drawings.

All terms (including technological and scientific terms) used in the specification, unless defined otherwise, will be used as meanings which can be understood by a person having ordinary knowledge in the art to which the present invention pertains in common. Furthermore, terms used and defined in common dictionaries should not be construed as having ideal or excessively formal meanings unless specifically defined otherwise.

Embodiments of the present invention are described hereinafter in detail with reference to the accompanying drawings, in order for a person having ordinary skill in the art to which the present invention pertains to carry out the present invention.

In order to help understanding of the present invention, first, various types of pixel structures used in a display device are described.

The number of red or blue pixels is half that of PenTile pixels, whereas the number of green pixels has the same structure as display resolution. That is, the R or B pixels are disposed between the green pixels in an X axis. An S-stripe pixel does not produce image artifacts that are seen by a human eye. However, the S-stripe pixel has a smaller aperture ratio than and shorter lifespan than the PenTile pixel.

Furthermore, for another example, a diamond PenTile pixel has a subpixel configuration 45 degrees rotated from the PenTile pixel structure. The PenTile and he diamond PenTile may have a maximum aperture ratio in calculation. In such two pixel configurations, spatial color resolution of red and blue pixels is half resolution of green pixels because the number of red and blue pixels is half the number of green pixels.

Furthermore, for another example, super AMOLED Plus is present, and has three color configurations in a unit pixel. The super AMOLED Plus may represent actual color, and is called diamond PenTile having a super AMOLED. This is almost the same as an LCD display having a common color. The subpixels of the super AMOLED Plus are arranged along with unit pixel boundaries. In the super AMOLED Plus, image artifacts have not been reported, but there are disadvantages in that the aperture ratio is small in a high resolution display, a fabrication process is very complicated, and the cost is high.

Furthermore, for another example, there is a Delta pixel) (or HoneyComb Pixel) having a triangle pixel, and subpixel arrangements thereof may have a honeycomb shape. The aperture ratio of the Delta pixel is much smaller than the aperture ratio of PenTile as required display resolution is further increased in a given process technology.

As described above, many and various types of pixel configurations are attempted and adopted to produce a high resolution OLED screen having a high aperture ratio and smaller image artifacts.

FIG. 2 is a diagram schematically illustrating a display device according to an embodiment of the present invention. Referring to FIG. 2, the display device according to an embodiment of the present invention may include a display panel 100, a data driving circuit 110, a gate driving circuit 120, and a timing controller 130.

The display panel 100 may be implemented as an OLED panel. However, the display panel 100 to which the present invention is applied may also be implemented as a liquid crystal display panel, a plasma display panel or an electrophoresis display panel.

Multiple unit pixels PXL may be formed in the display panel 100. Each of the unit pixels may be configured in a form to be described later. Each of the unit pixels may include a plurality of subpixels that represent a specific color. According to an embodiment of the present invention, adjacent subpixels between adjacent unit pixels may represent a pyramid form.

At least one data line DL and at least one gate line GL may be allocated to each of the unit pixels PXL. A red subpixel includes a red OLED having a red light-emitting layer. A green subpixel includes a green OLED having a green light-emitting layer. A blue subpixel includes a blue OLED having a blue light-emitting layer. The OLED further includes a first electrode (e.g., cathode) stacked on the light-emitting layer and a second electrode (e.g., anode) stacked under the light-emitting layer, and may emit light using a top emission method. The light-emitting layer emits light by a driving current applied from a TFT array via the second electrode. An opening part means a region in which light generated from the light-emitting layer is displayed as an image in the subpixel. Hereinafter, for convenience of description, the term "opening part" is omitted in the array structure of subpixels.

The data driving circuit 110 includes multiple source integrated circuits and drives the data lines DL of the display panel 100. The data driving circuit 110 converts input digital video data into a data voltage and supplies the data voltage to the data lines DL under the control of the timing controller. The data voltage is applied to the TFT array through the data lines DL, and determines a driving current supplied from a driving element to the second electrode.

The gate driving circuit 120 includes one or more gate drive ICs, and sequentially supplies a scan pulse (or gate pulse) to the gate lines GL of the display panel 100. In a gate in panel (GIP) method, the gate driving circuit 120 may include a shift register formed in the display panel 100.

The timing controller 130 receives multiple timing signals from an external system (not illustrated) and generates control signals for controlling operating timing of the data driving circuit 110 and the gate driving circuit 120. The timing controller 130 receives digital video data from the system and supplies the digital video data to the data driving circuit 110.

Hereinafter, various types of each unit pixel configuring the display panel 100 according to various embodiments of the present invention are described.

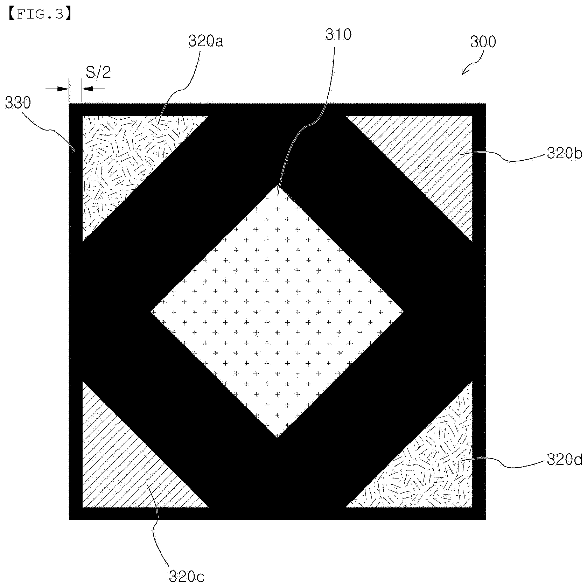

FIG. 3 is a diagram illustrating the subpixel array structure of each unit pixel in the display device according to a first embodiment of the present invention. Referring to FIG. 3, a unit pixel 300 according to an embodiment of the present invention may be configured to include a plurality of subpixels 310 and 320 as shown. The display device may be configured by repeating a plurality of the unit pixels.

More specifically, the unit pixel 300 may include at least one red subpixel, at least one green subpixel and at least one blue subpixel. In the following drawings, different colors of subpixels are differently indicated in different pattern forms.

As shown, the unit pixel 300 may have a square form. According to various embodiments, the unit pixel 300 may have a rectangle form. In the following embodiment, a square is described as an example, for convenience of description.

The first subpixel 310 having a first color (e.g., green) is positioned at the center of the unit pixel 300 having the square. Second subpixels 320a and 320d having a second color (e.g., blue or red) are disposed at two corners that are diagonal to each other among the four corners of the unit pixel 300. Third subpixels 320b and 320c having a third color (e.g., red or blue) are disposed at two corners that are diagonal to each other among the four corners.

According to an embodiment of the present invention, as shown, the second subpixels and third subpixels 320 are isolated and disposed from boundaries between the unit pixels 300 by a designated length. Accordingly, as shown in FIG. 3, the edge of each unit pixel forms a region 330 isolated at a given interval (e.g., S/2) and may become a space in which a pixel is not positioned.

According to an embodiment of the present invention, the first subpixel 310 positioned at the center may occupy a larger area than the second subpixel or third subpixel 320 positioned at each corner. Green may be disposed in the first subpixel. In contrast, the second subpixel or third subpixel 320 positioned at each corner may occupy a smaller than the first subpixel 310 positioned at the center. Blue or red may be positioned in the second or third subpixel.

The same color may be positioned in the second subpixel or third subpixel 320 positioned at each corner with respect to subpixels that are diagonal to each other. For example, the same color as that of the second subpixel 320d at the bottom right corner may be positioned in the second subpixel 320a at the top left corner. The same color as that of the third subpixel 320c at the bottom left corner may be positioned in the third subpixel 320b at the top right corner.

According to an embodiment of the present invention, the first subpixel 310 positioned at the center may have a diamond form, but the present invention is not limited thereto. Furthermore, the second subpixel or third subpixel 320 positioned at each corner may have a triangle form, but the present invention is not limited thereto.

A display pixel needs to have a sufficiently high aperture ratio in order to support sufficiently long lifespan and smaller image artifacts. In order to achieve the former, a region occupied by a PDL (or PDG) in the pixel configuration needs to be minimized. A region in which a light-emitting device may be disposed needs to be reduced. The latter is related to the arrangement of subpixels in the unit pixel. The pixel structure of FIG. 3 according to an embodiment of the present invention can minimize image artifacts compared to a high aperture ratio.

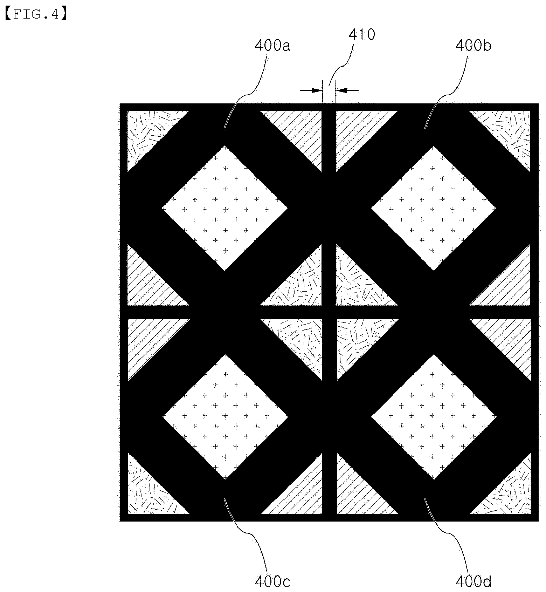

FIG. 4 is a diagram illustrating a 2×2 pixel array implemented in a subpixel array structure, such as FIG. 3. Referring to FIG. 4, the unit pixel of FIG. 3 may be repeatedly formed in plural number.

According to an embodiment of the present invention, in unit pixels 400b and 400c adjacent to a first unit pixel 400a, the colors of second subpixels or third subpixels may be differently disposed so that subpixels having the same color are disposed between adjacent unit pixels.

For example, in the first unit pixel 400a, as in FIG. 3, the second subpixel may be positioned as blue, and the third subpixel may be positioned as red. In the second unit pixel 400b adjacent to the right of the first unit pixel 400a, unlike in FIG. 3, the second subpixel may be positioned as red, and the third subpixel may be positioned as blue.

If the subpixels are disposed as described above, the third subpixel positioned at the top right corner of the first unit pixel 400a and the second subpixel positioned at the top left corner of the second unit pixel 400b may have the same red color. Likewise, the second subpixel positioned at the bottom right corner of the first unit pixel 400a and the third subpixel positioned at the bottom left corner of the second unit pixel 400b may have the same blue color.

According to the same method, if the third unit pixel 400c adjacent to the bottom of the first unit pixel 400a is disposed as the same color as the second unit pixel 400b, adjacent subpixels may have the same color as described above. Likewise, the fourth unit pixel 400d may be positioned as the same color as the first unit pixel 400a.

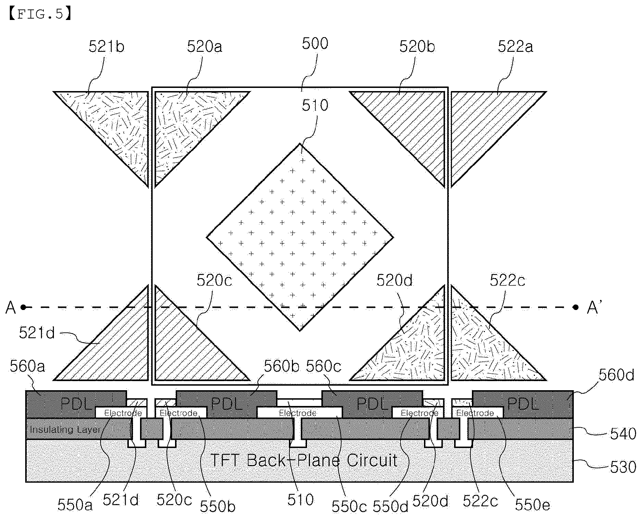

Adjacent subpixels having the same color in two adjacent unit pixels may be divided by an electrode, which will be described in detail with reference to FIGS. 5 to 7.

According to an embodiment of the present invention, at least one subpixel of the first unit pixel 400a and at least one subpixel of the second unit pixel 400b adjacent to the first unit pixel 400a may be merged to have a pyramid form. In FIG. 4, the unit pixels have been illustrated as being isolated with a given isolated region 410, but may be divided by an electrode as described above.

Referring to FIG. 4, all the subpixels (R/G/B) having a pyramid form according to an embodiment of the present invention have the centers of the subpixels having three colors arranged at the same location, which can minimize image artifacts.

For example, as shown in FIG. 4, a pyramid pixel according to an embodiment of the present invention has 5 subpixels representing the R, G, and B of the three colors. They correspond to one color or pixel (e.g., green) and two pairs of different colors (e.g., red and blue). Green is located at the center of a unit pixel, each of red and blue is divided into two subpixels, and the same colors are diagonally disposed at corners on the opposite side.

If each pixel emits light, the centers of the colors of the subpixels are identically arranged at the center of a unit pixel. As a result, image artifacts do not appear. In addition, to display image/media data on pyramid pixels does not require additional image data processing because all unit pixels include R/G/B subpixels.

FIG. 5 is a diagram illustrating the vertical structure of a pyramid pixel according to a first embodiment of the present invention. Referring to FIG. 5, a first unit pixel 500 may include a plurality of subpixels 510 and 520. As described above, second subpixels 520a and 520d and third subpixels 520b and 520c disposed at respective corners of the first unit pixel 500 may be positioned with the same color as adjacent subpixels of adjacent unit pixels 521 and 522.

When the display device is vertically viewed in A-A', a TFT back plane circuit 530, an insulating material layer 540, an electrode 550, and subpixels 510, 520, 521, and 522 in a cross section shape may be sequentially stacked and configured. A PDL 560 may be formed between the subpixels.

As described above, adjacent subpixels between unit pixels may be disposed with the same color, and may be divided by an electrode. For example, in FIG. 5, subpixels 521d and 520c are adjacently disposed with the same color, but may be separated by electrodes 550a and 550b. Likewise, in FIG. 5, subpixels 520d and 522c are adjacently disposed with the same color, but may be separated by electrodes 550d and 550e.

As shown in FIG. 5, in the vertical structure of the pyramid display panel, subpixels having different colors are divided by the PDL 560. However, subpixels having the same color may be separated by the electrodes 550 disconnected for the corresponding subpixels. A pyramid pixel according to an embodiment of the present invention minimizes a pixel region that becomes extinct by the PDL 560 (or PDG), and thus minimizes a loss of the aperture ratio. Furthermore, such a method can simplify a fabrication process flow.

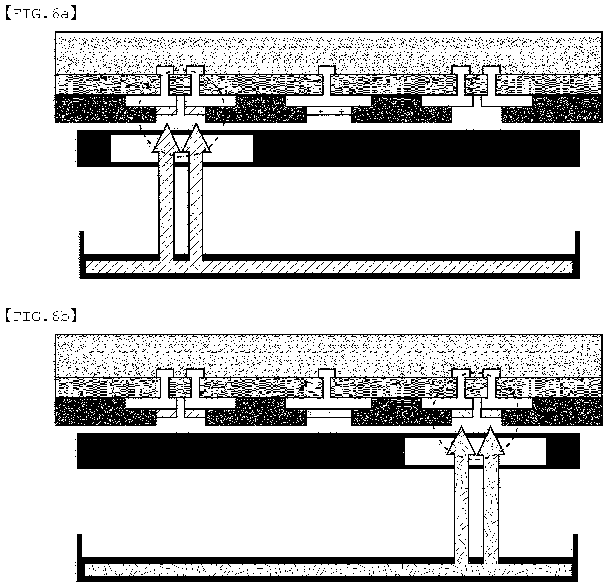

FIGS. 6a and 6b are diagrams illustrating a process of fabricating a pyramid pixel according to an embodiment of the present invention.

The constituent materials of OLEDs capable of representing R/G/B are different, and subpixels having different colors are fabricated through a separate FMM having openings having different forms/sizes for each subpixel. Accordingly, in order to fabricate a panel capable of representing all of R/G/B, a process using different at least three FMMs needs to be performed. The FMM is made of a thin alloy material using a kind of shadow masking method. An OLED TFT is fabricated by depositing an OLED material on a TFT circuit board through a hole perforated in the FMM.

The pixel definition layer/gap (PDL/PDG) is stacked using a non-conductive material in order to separate subpixels, and becomes an element to determine an interval between subpixels having different colors. If the width of the PDL/PDG is not sufficiently great or not constant, the irregularity of an OLED element form, size, and characteristic may occur in each pixel because an error of several process steps for coating an OLED material on a TFT substrate is accumulated.

Furthermore, if the TFT substrate and the FMM are not fully close to each other, a deposition material may be spread between subpixels. Accordingly, by considering such an error range, the width of the PDL is determined so that subpixel regions can be sufficiently insulated. For example, a current technology requires a PDL width of 18 $\mu$m. If the amount of accumulation of the errors is too large compared to the PDL, there is a danger of color blurring between different subpixels and an abnormal excess emission phenomenon when an upper electrode is formed and power is applied because different subpixel materials are overlapped in the process.

Meanwhile, the FMM is fabricated by perforating a hole, having a desired shape, in a high strength alloy plate having a small (several tens of $\mu$m) thickness through an etching method using a strong acid solution or laser. Etch forms and sizes of the top and bottom of the FMM are a little differently formed because lateral etch (or side etch) cannot be fully prevented although etching is precisely controlled. Accordingly, an additional FMM and a separate deposition process using the FMM are necessary in order to fabricate a high-resolution display panel depending on an array form of subpixels. For example, in the case of a pattern such as a blue pixel of an S-stripe pixel or a super AMOLED Plus pixel, in order to deposit only a blue subpixel, the pixel needs to be fabricated using a dual deposition method of twice depositing two FMMs separately. In the case of the super AMOLED Plus pixel, in order to fabricate a high resolution panel, all subpixels need to be fabricated through a special and complicated process, such as a dual deposition method.

Meanwhile, referring to FIGS. 6a and 6b, in the pyramid pixel structure according to an embodiment of the present invention, some of or all subpixels having the same color at adjacent locations are separated by separating the electrode of an OLED element not a PDL gap.

Subpixels separated by the electrode as described above, as shown, can be fabricated through one deposition process using one FMM. Accordingly, an additional process step, such as a dual deposition scheme, does not need to be performed, and thus additional equipment or material such as a dual FMM set is not necessary.

Meanwhile, the electrode for driving the OLED element is formed in a TFT circuit board fabrication process, that is, a step prior to OLED material deposition in the process. Accordingly, the electrode can be fabricated by controlling a width and interval in a unit (several $\mu$m level: 3 $\mu$m in a recent technology or a level less than 3 $\mu$m is possible) much smaller than the process requirement (18 $\mu$m is a recent technology) of a PDL gap. Accordingly, the electrode can be fully free of problems in the OLED deposition process, such as the FMM itself, an FMM arrangement error, or the accuracy of adhesion, or limits in the fabrication condition. Accordingly, an embodiment of the present invention has advantages in that it is rarely affected by the aperture ratio while separating pixels.

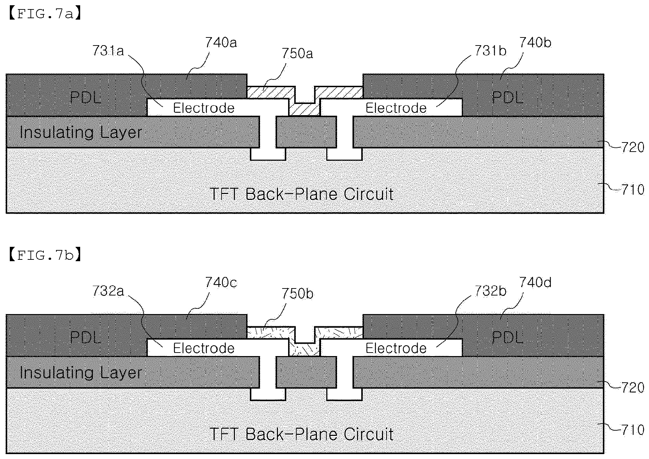

FIGS. 7a and 7b are diagrams illustrating cross sections of a pyramid pixel fabricated according to an embodiment of the present invention. Referring to FIGS. 7a and 7b, a TFT back plane circuit 710, an insulating material layer 720, an electrode 731, and an OLED material 750 configuring a subpixel are sequentially stacked. Subpixels 750 having different colors may be separated by a PDL 740.

According to an embodiment of the present invention, referring to FIG. 7a, subpixels having the same color may be divided by a plurality of electrodes 731a and 731b. By separating the electrode 731a and 731b as described above, an OLED material 750a can be coated without an additional subpixel separation process when the subpixels are divided. Likewise, referring to FIG. 7b, subpixels having the same color may be separated by a plurality of electrodes 732a and 732b. By separating the electrode 732a and 732b as described above, an OLED material 750b can be coated without an additional subpixel separation process when subpixels are divided.

For example, as shown in FIGS. 7a and 7b, the OLED material is coated at a region where the electrodes 731a, 731b, 732a, and 732b are not present. However, the OLED material coated on the region where the electrodes are not present cannot contribute to an emission action as a display element. That is, a correlation of an electrical potential level at which the OLED material operates as a semiconductor and a light-emitting element is not maintained. A distance (several μm) between the electrodes is smaller than a minimum interval requirement (18~20 μm) of a PDL, but is relatively too far in terms of an operating condition for an OLED element. Meanwhile, the OLED uses a phenomenon occurring in a range of several hundreds of nm. Accordingly, in the present invention, subpixels disposed in a relatively narrow distance can be identified using an electrode based on such a principle.

Meanwhile, to display an image/media data on pyramid pixels fabricated by a process according to an embodiment of the present invention does not require additional image data processing because all unit pixels include R/G/B subpixels.

The fabrication of the pyramid pixel according to an embodiment of the present invention does not require a complicated and additional process step, and also does not require an additional material used in stripe and super AMOLED Plus fabrication.

The aperture ratio of the pyramid pixel is close to the aperture ratio of PenTile and diamond PenTile, but is slightly larger than the aperture ratio of the Delta pixel. The aperture ratio of the pyramid pixel is much larger than that of the S-stripe and super AMOLED Plus pixel. In the pyramid pixel, the region occupied by the PDL (or PDG) is the same as that of the diamond PenTile.

Accordingly, in the pyramid pixel in which subpixels having the same color are separated by separating the electrodes, if an OLED material is coated without a separate and additional pixel separation process, a portion where an OLED element that may act as a light-emitting material in a corresponding vertical structure may be indicated as in FIG. 5.

Hereinafter, the pyramid pixel structure according to an embodiment of the present invention is compared with various forms of pixel structures. More specifically, aperture ratios and image artifacts between the pixel structures are compared.

The aperture ratio may be represented like <Equation 1>.

$$[\text{Equation 1}]$$

$$\text{Aperture ratio}[\%] =$$

$$\frac{\text{Area of light} - \text{emitting unit or area of light transmission unit in unit pixel}}{\text{Total area of unit pixel}} \times 100$$

A form of a unit pixel for calculating the aperture ratio may be defined as follows.

- P = Pitch & L of unit pixel = minimum PDL gap
- S = Minimum electrode space (minimum interval between electrodes)

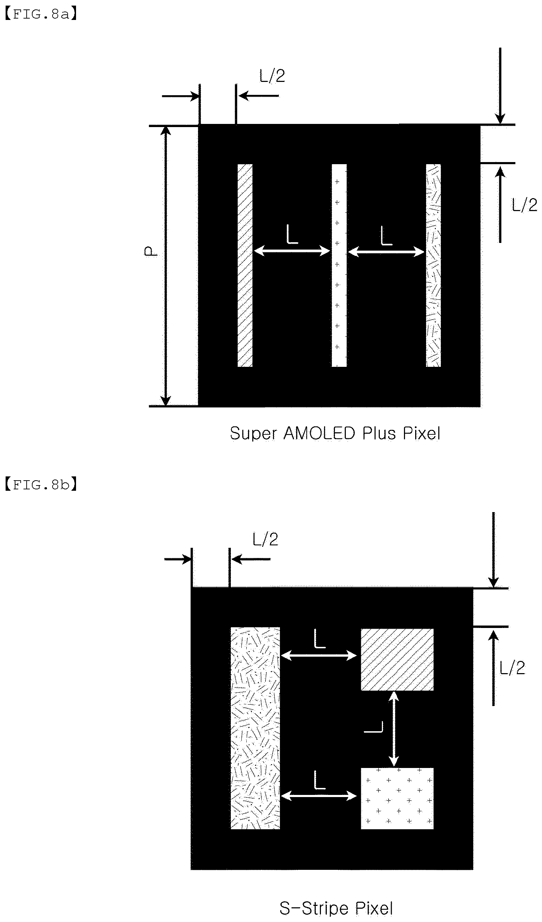

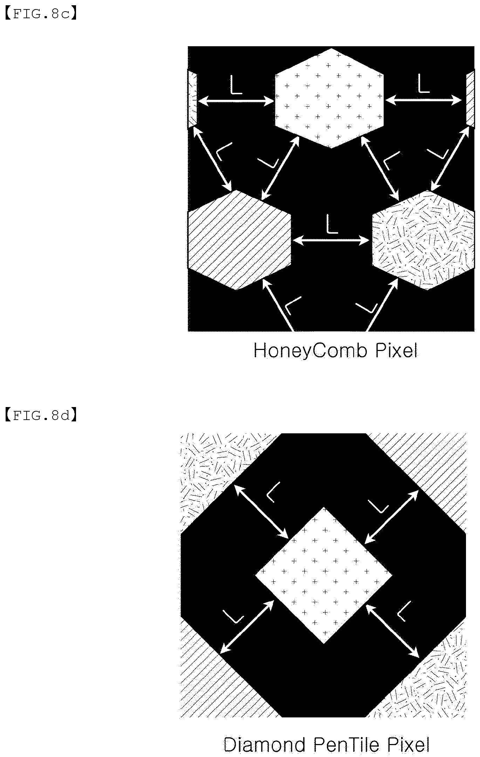

FIGS. 8a to 8h are diagrams illustrating various forms of subpixel array structures for a unit pixel. FIG. 8a is a super AMOLED Plus pixel structure. FIG. 8b is an S-stripe pixel structure. FIG. 8c is a Delta (or Honeycomb) pixel structure. FIG. 8d is a diamond PenTile pixel structure.

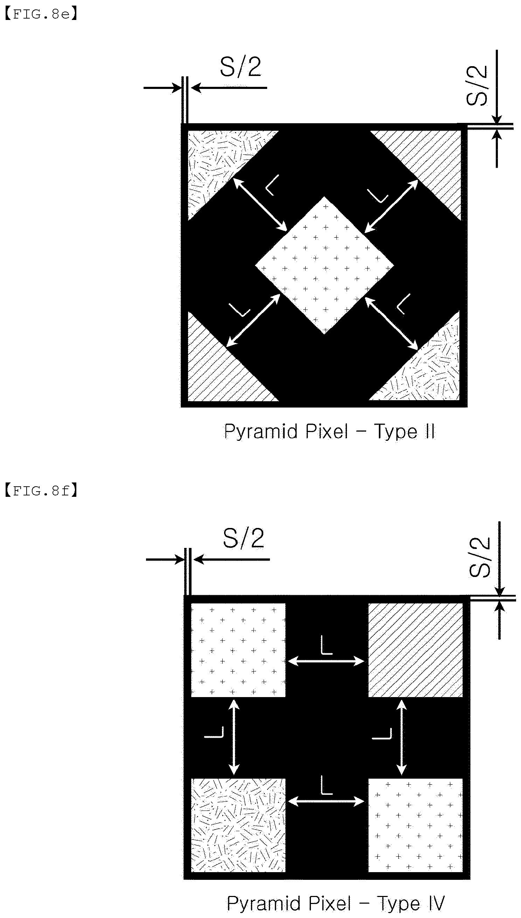

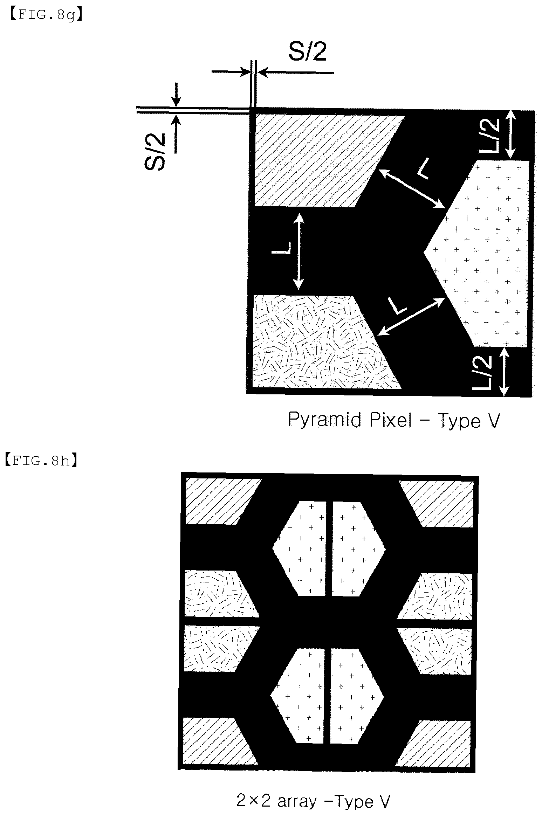

FIG. 8e is a pyramid pixel structure according to an embodiment of the present invention. FIGS. 8f, 8g, and 8h are modified pyramid pixel structures according to other embodiments of the present invention.

In the PenTile pixel structure, R/B subpixels are alternately placed based on a subpixel G in terms of the structure, and driving thereof is determined based on image data processing, but have been considered as being divided based on the subpixel G for aperture ratio calculation and comparison. In a pyramid pixel according to an embodiment of the present invention, the boundary between the R/B subpixels is isolated from the boundary of a unit pixel by S/2 (half the interval between electrodes). The pixel structures in FIGS. 8f and 8g are structures capable of maximizing the aperture ratio. FIG. 8e has an advantage in that image artifacts can be minimized.

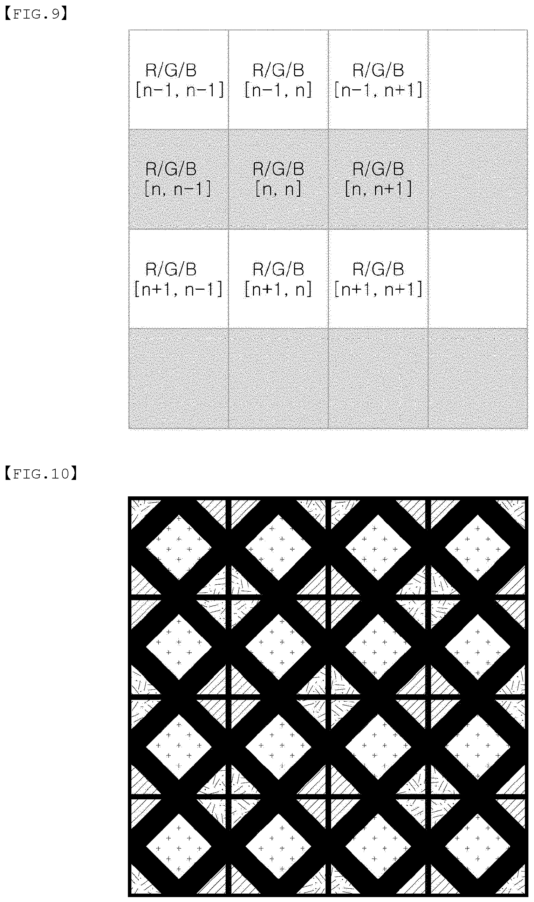

FIG. 9 is a diagram illustrating the structure of image data according to an embodiment of the present invention. FIG. 10 is a diagram illustrating a 4×4 pyramid pixel array according to an embodiment of the present invention.

In a conventional PenTile pixel structure, an image data pre-processing process was necessary in order to solve mismatching between common image data and a PenTile pixel array. For example, the number of R/B single color pixels is half the number of G pixels, and the R/B pixels are positioned at locations tilted 45 degrees from the G pixel. Accordingly, when mixed color light is represented at specific G coordinates, there is a need for logic or an algorithm capable of determining what R and what B will be driven at which ratio.

In contrast, as shown FIG. 10, the pyramid pixel structure according to an embodiment of the present invention does not have mismatching between image data and subpixels because each unit pixel includes all R/G/B. Accordingly, an image data pre-processing process, such as that in the PenTile pixel array, is not necessary.

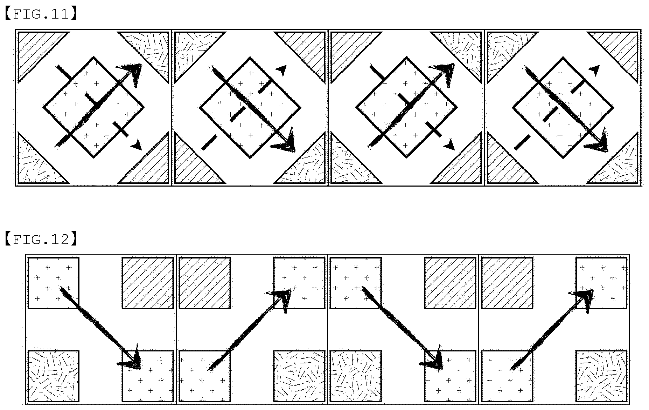

FIGS. 11 to 13 are diagrams for describing image artifacts of a pyramid pixel according to an embodiment of the present invention.

Referring to FIG. 11, in the pixel structure according to an embodiment of the present invention, a zigzag pattern is formed when a traverse/longitudinal straight line of a single R or B color is represented. The zigzag pattern is smaller than the Pentile, and green maintains a fully balanced arrangement state.

Referring to FIG. 12, in the pixel structure according to an embodiment of the present invention, when a traverse/longitudinal straight line is represented as green, a zigzag pattern is formed, and a zigzag width is the smallest.

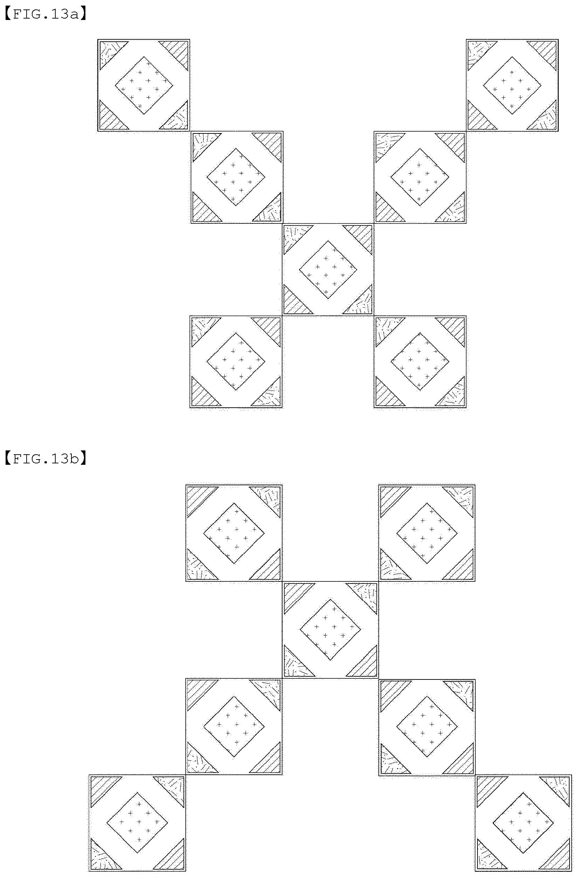

Referring to FIGS. 13a and 13b, the pixel structure according to an embodiment of the present invention does not have a constraint condition for coordinates/color in representing an image in an oblique line. Accordingly, there is an advantage in that a separate algorithm for solving and reducing a constraint condition is not necessary.

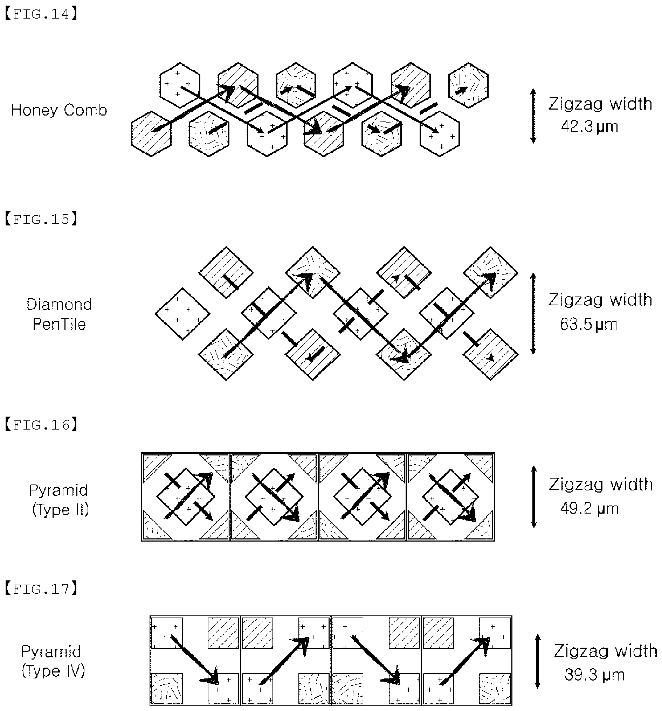

FIGS. 14 to 17 are diagrams for describing image artifacts for various types of pixel arrays. In FIGS. 14 to 17, a 400PPI pixel array (pixel pitch = 63.5 $\mu$m) and a process technology (PDL = 18 $\mu$m, an electrode interval=3 $\mu$m) were assumed. It was assumed that in one pixel structure, the areas of R/G/B subpixels are the same.

Referring to FIGS. 14 to 17, in the pyramid pixel structure according to an embodiment of the present invention, a zigzag width is small and image artifacts can be minimized compared to conventional structures. When the structures are compared in a predetermined process condition, it can be seen that the aperture ratio of the pyramid pixel according to an embodiment of the present invention is large slightly or significantly compared to other pixel structures. In order to implement a high resolution display, a difference may be further increased as the size of a unit pixel is reduced.

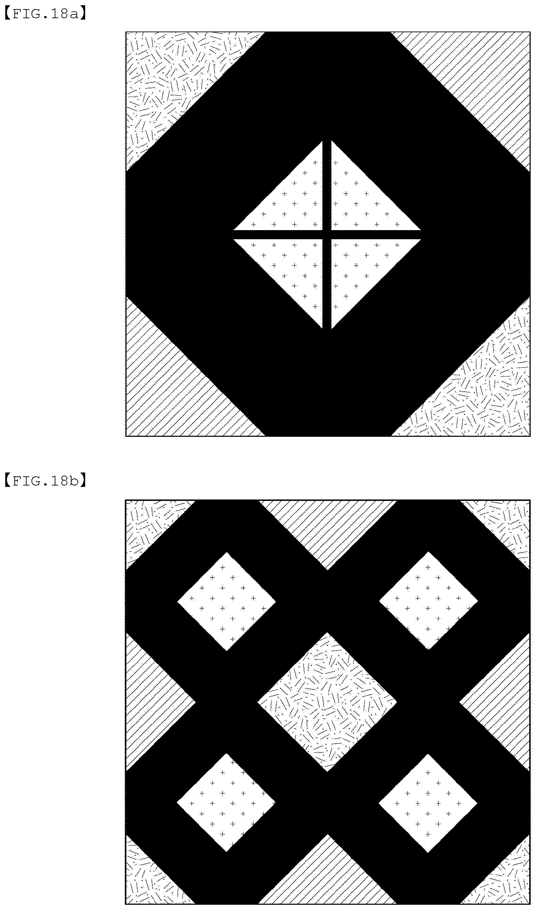

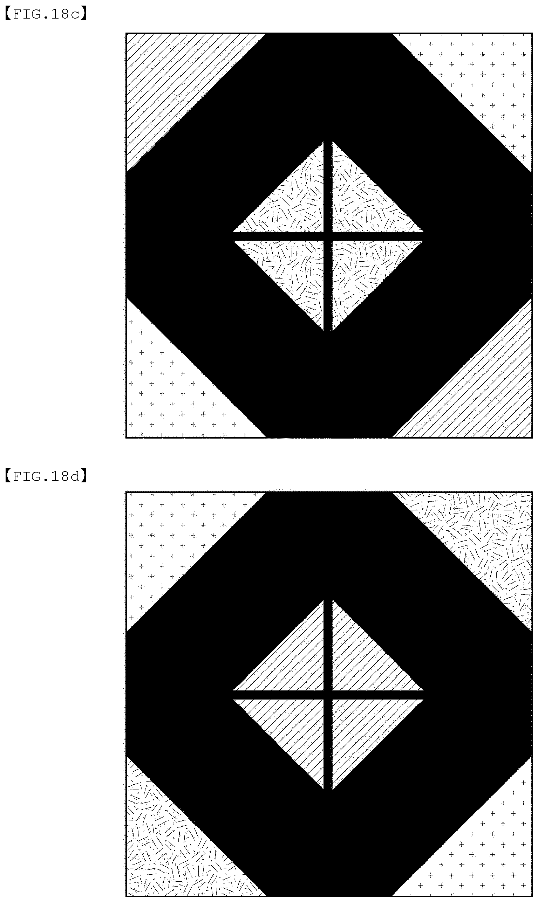

FIGS. 18 to 29 are diagrams illustrating subpixel array structures having modified forms of unit pixels according to various embodiments. Referring to FIGS. 18 to 29, according to various embodiments of the present invention, the subpixel array structures may be modified and practiced in various forms.

For example, from a structural aspect, the present invention may include all pixel structures in which when multiple unit pixels are arranged in a 2-dimensional plane, a plurality of unit pixels having the same color or subpixels as some of the unit pixels may have vertexes that are located at the closest distance and brought into contact with each other and the plurality of unit pixels (or subpixels) can be fabricated at the same time during a process.

Furthermore, a pixel form obtained when a unit pixel or subpixels having such a structure and form are rotated or twisted at a given angle is also included in the pyramid pixel.

FIGS. 18a to 18d are modified forms of a pyramid pixel. Only a pixel having one color within the unit pixel may be positioned to have a pyramid form. FIG. 18a shows a unit pixel. FIG. 18b shows the pixels having a 2×2 array. FIGS. 18c and 18d show examples in which the arrangements of colors in FIG. 18a are different.

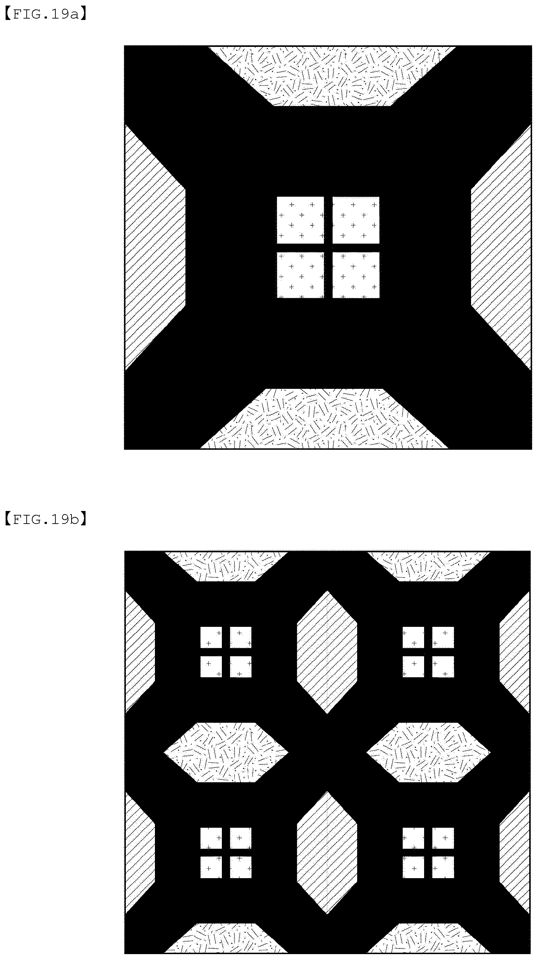

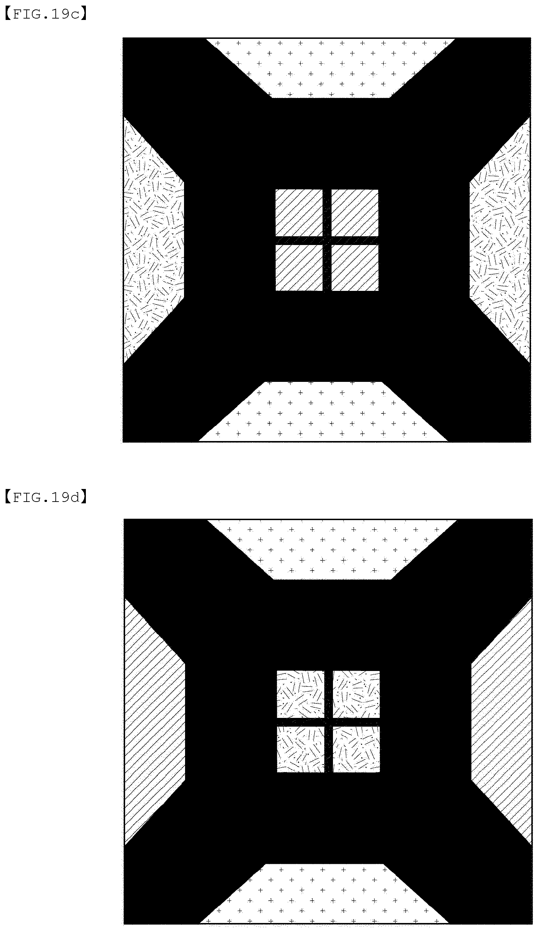

FIGS. 19a to 19d are modified forms of a pyramid pixel, and show forms in which in the arrangements of FIGS. 18a to 18d, each of the color pixels has been rotated 45 degrees and positioned. FIG. 19a shows a unit pixel. FIG. 19b shows the pixels having a 2×2 array. FIGS. 19c and 19d show examples in which the arrangements of colors in FIG. 19a are different.

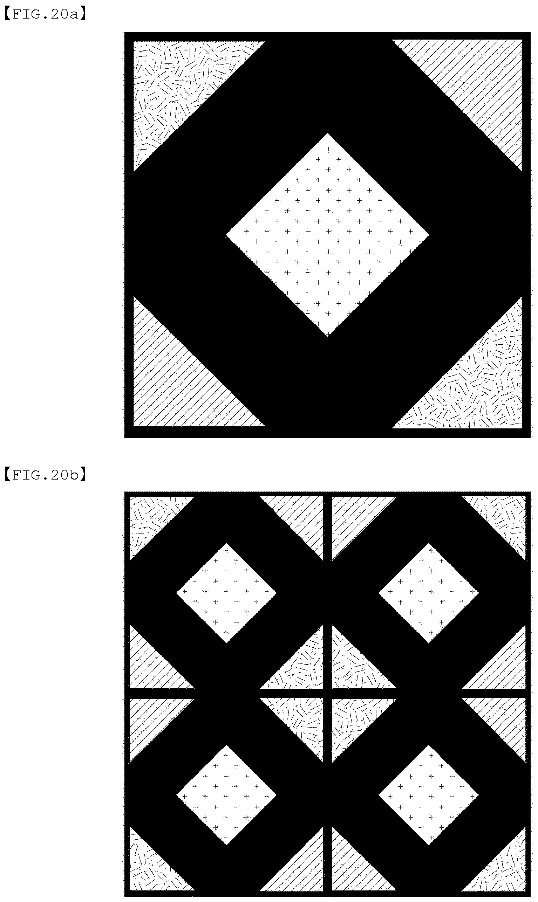

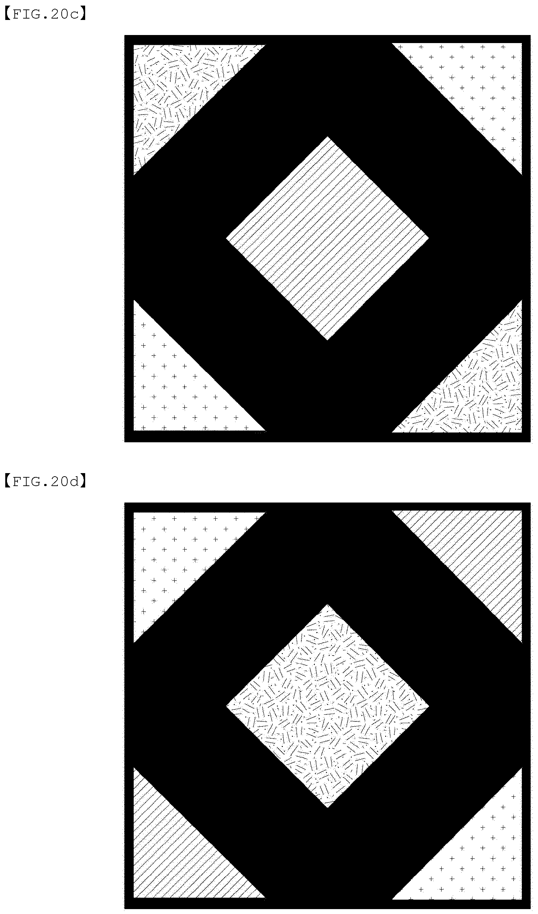

FIGS. 20a to 20d are modified forms of a pyramid pixel. Pixels having two colors may be disposed to have a pyramid form within a unit pixel. FIG. 20a shows the unit pixel. FIG. 20b shows the pixels having a 2×2 array. FIGS. 20c and 20d show examples in which the arrangements of colors in FIG. 20a are different.

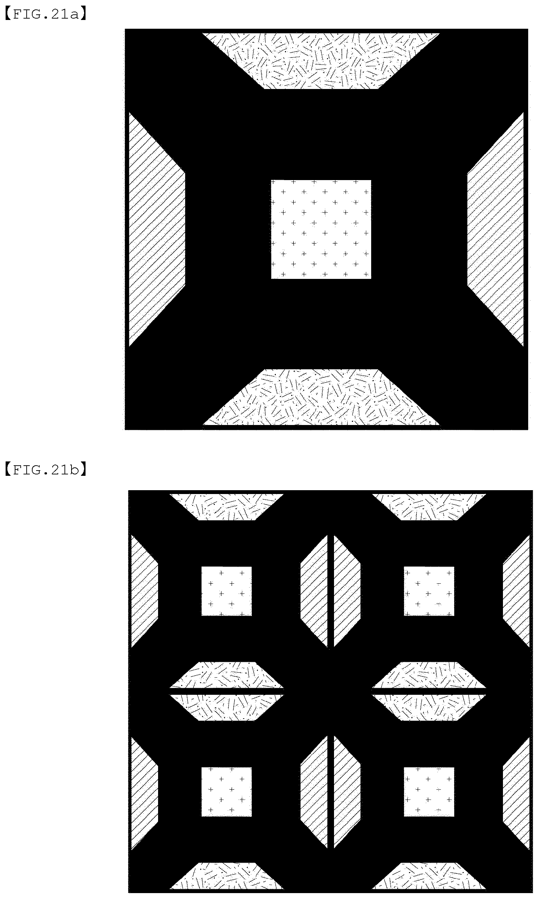

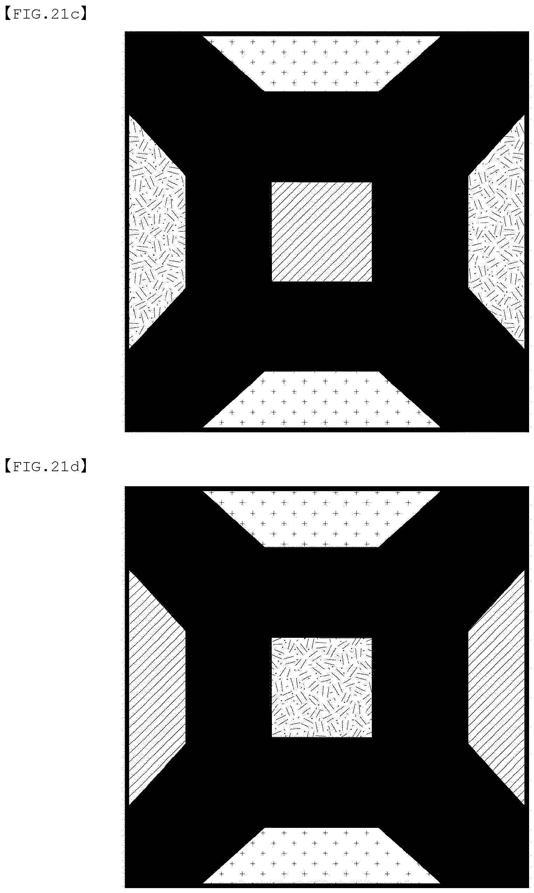

FIGS. 21a to 21d are modified forms of a pyramid pixel, and show forms in which in the arrangements of FIGS. 20a to 20d, each of the color pixels has been rotated 45 degrees and positioned. FIG. 21a shows a unit pixel. FIG. 21b shows the pixels having a 2×2 array. FIGS. 21c and 21d show examples in which the arrangements of colors in FIG. 21a are different.

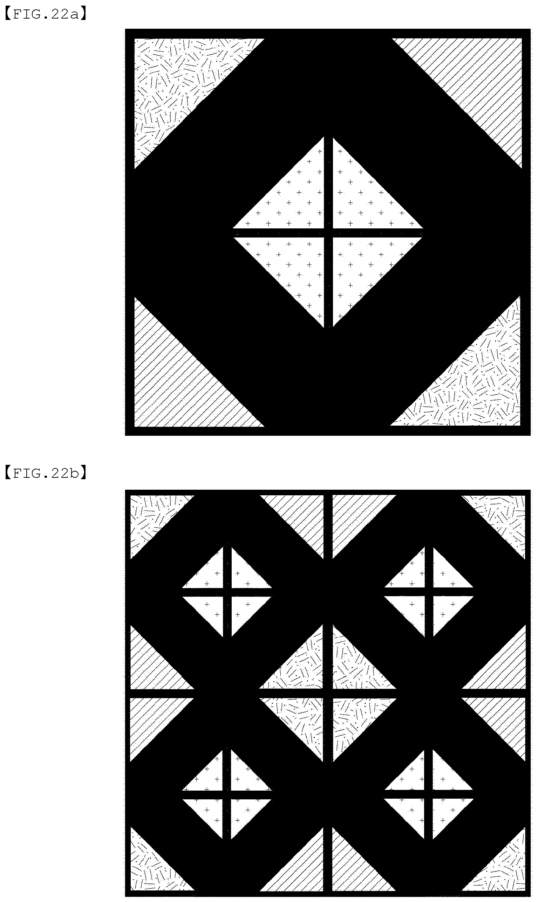

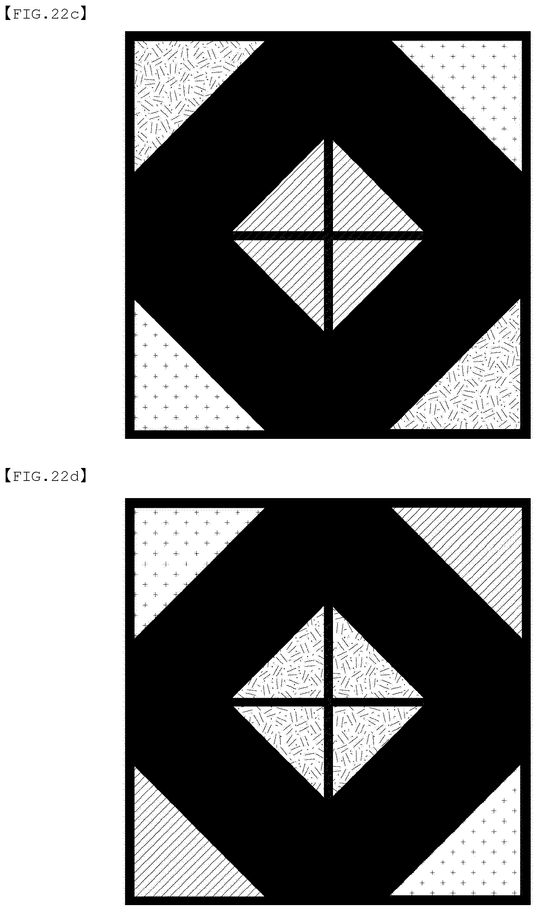

FIGS. 22a to 22d are modified forms of a pyramid pixel. Pixels having three colors may be disposed to have a pyramid form within a unit pixel. FIG. 22a shows the unit pixel. FIG. 22b shows the pixels having a 2×2 array. FIGS. 22c and 22d show examples in which the arrangements of colors in FIG. 22a are different.

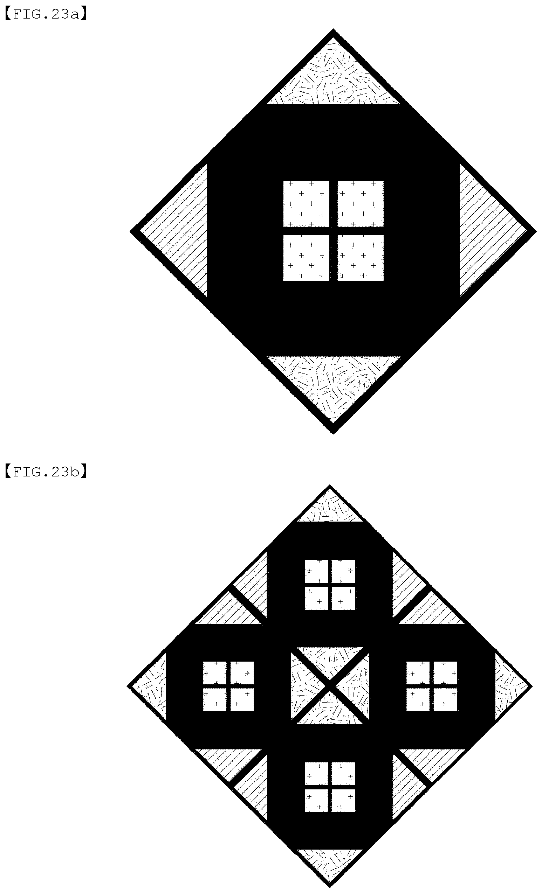

FIGS. 23a to 23d are modified forms of a pyramid pixel, and show examples in which a color pixel not constant in the arrangements of FIGS. 22a to 22d has a divided form. FIG. 23a shows a unit pixel. FIG. 23b shows the pixels having a 2×2 array.

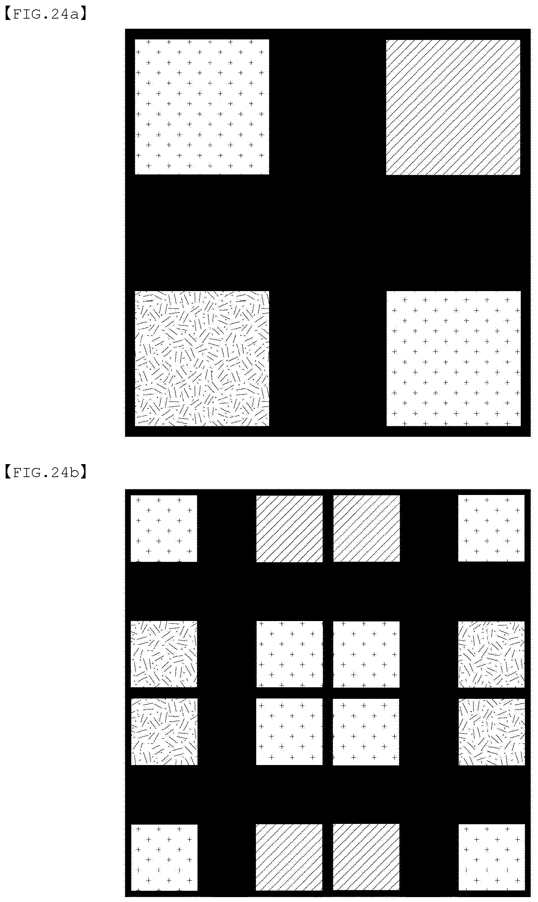

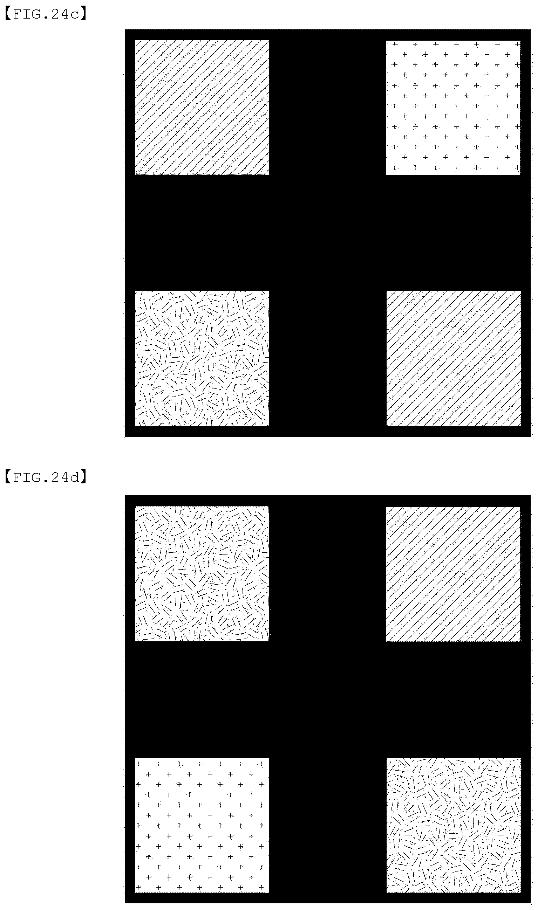

FIGS. 24a to 24d are modified forms of a pyramid pixel, and are forms in which the arrangements of FIGS. 20a to 20d have been modified. Referring to FIG. 24a, the subpixel of each color may be positioned at each corner, and may have a rectangle form. FIG. 24a shows a unit pixel. FIG. 24b shows pixels having a 2×2 array. FIGS. 24c and 24d show examples in which the arrangements of colors in FIG. 24a are different.

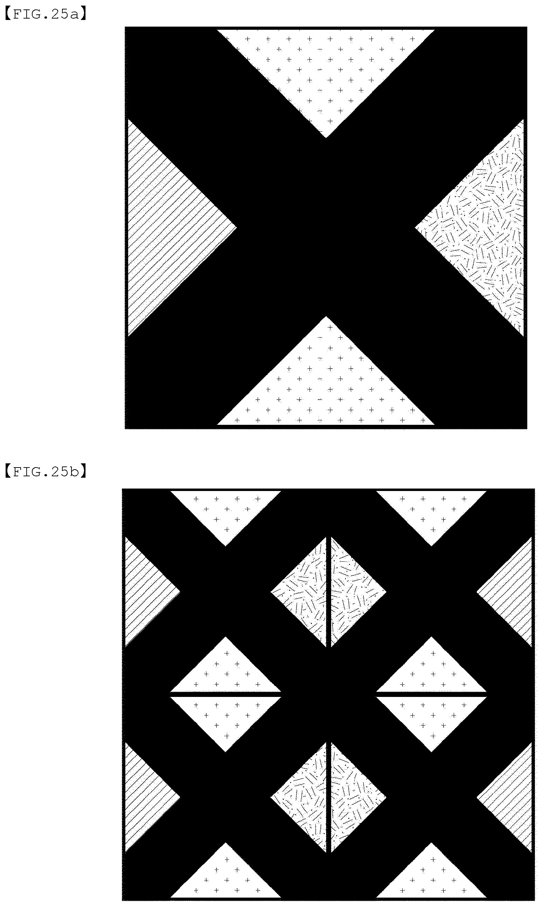

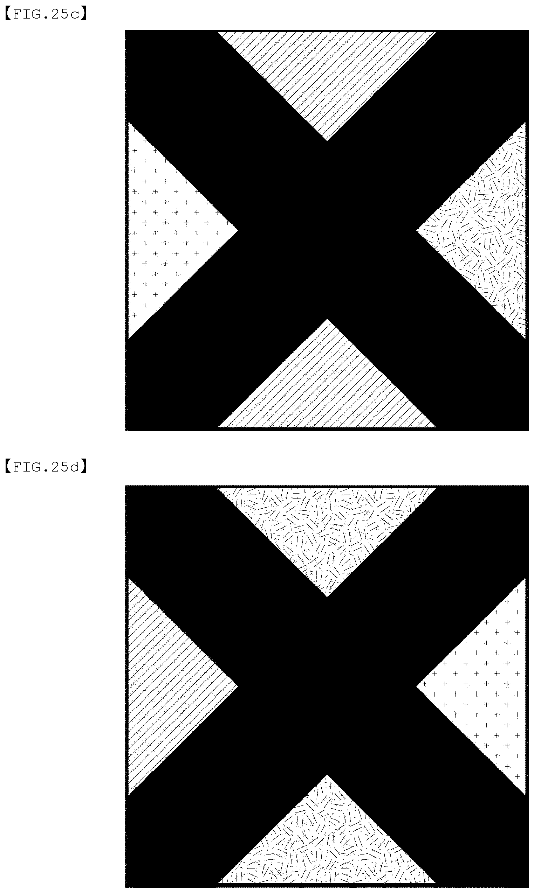

FIGS. 25a to 25d are modified forms of a pyramid pixel, and show forms in which in the arrangements of FIGS. 24a to 24d, each of the color pixels has been rotated 45 degrees and positioned. FIG. 25a shows a unit pixel. FIG. 25b shows the pixels having a 2×2 array. FIGS. 25c and 25d show examples in which the arrangements of colors in FIG.

25a are different.

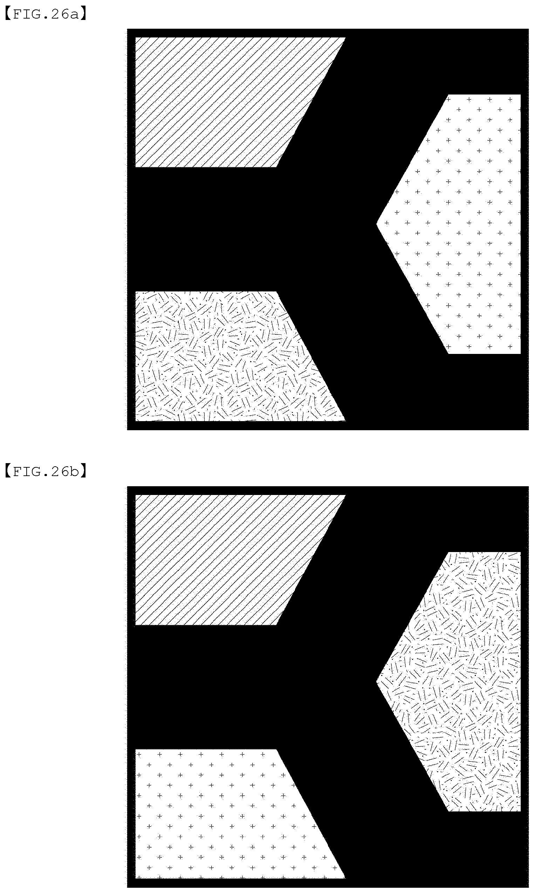

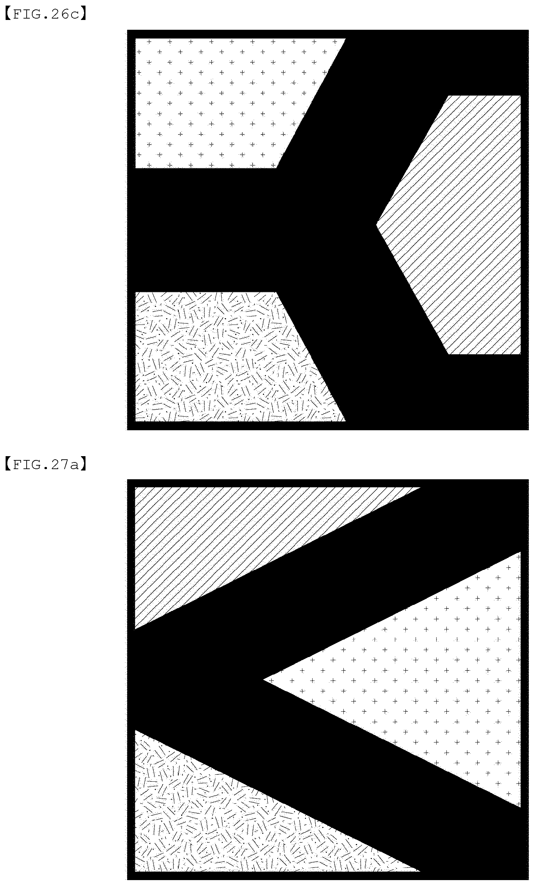

FIGS. 26a to 26c are modified forms of a pyramid pixel, and shows forms in which the arrangements of FIGS. 20a to 20d have been modified. Referring to FIG. 26a, the subpixel of each color may be positioned at each corner or side (e.g., may be positioned at two corners and one side), and may have a polygon form. FIG. 24a shows a unit pixel. FIGS. 24b and 24c show examples in which the arrangements of colors in FIG. 24a are different.

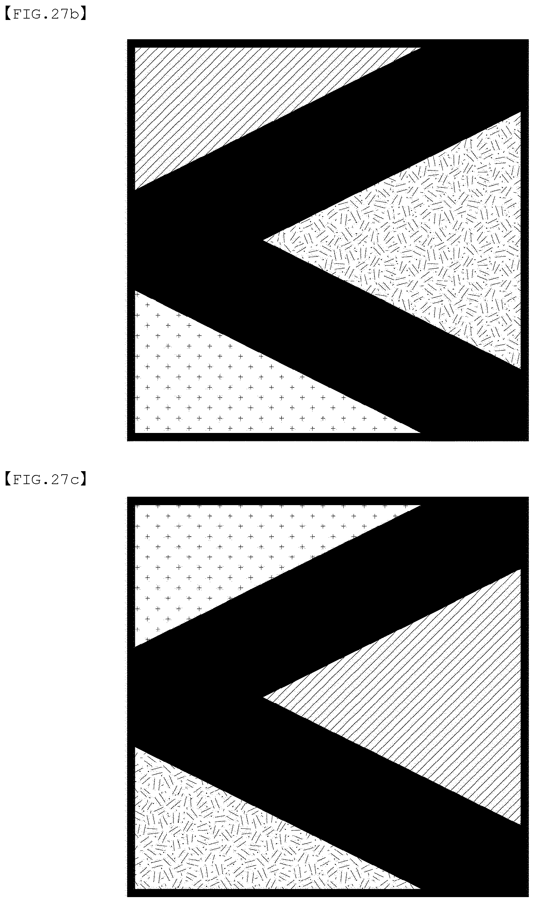

FIGS. 27a to 27c are modified forms of a pyramid pixel. In these drawings, the subpixel of each color may be positioned at each corner or side (e.g., may be positioned at two corners and one side), and may have a triangle form. FIG. 27a shows a unit pixel. FIGS. 27b and 27c show examples in which the arrangements of colors in FIG. 27a are different.

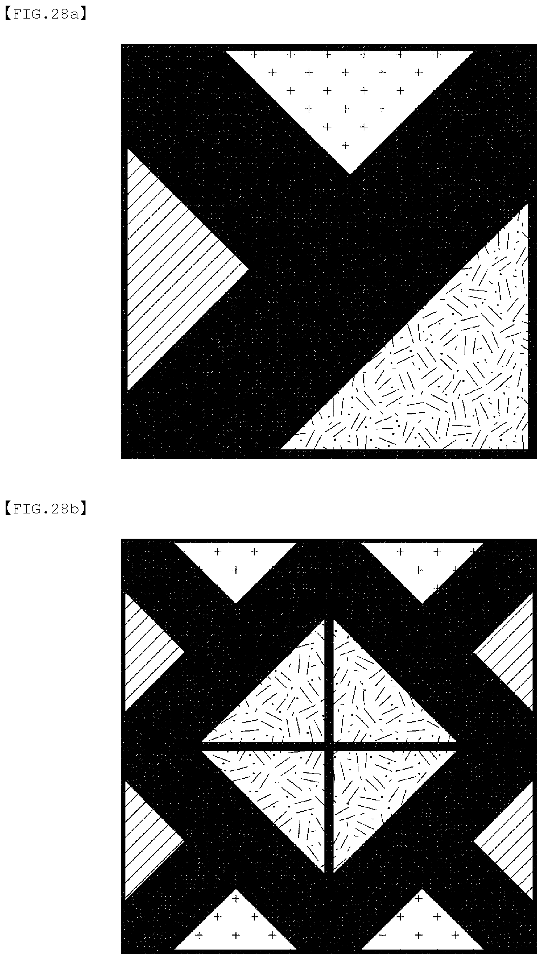

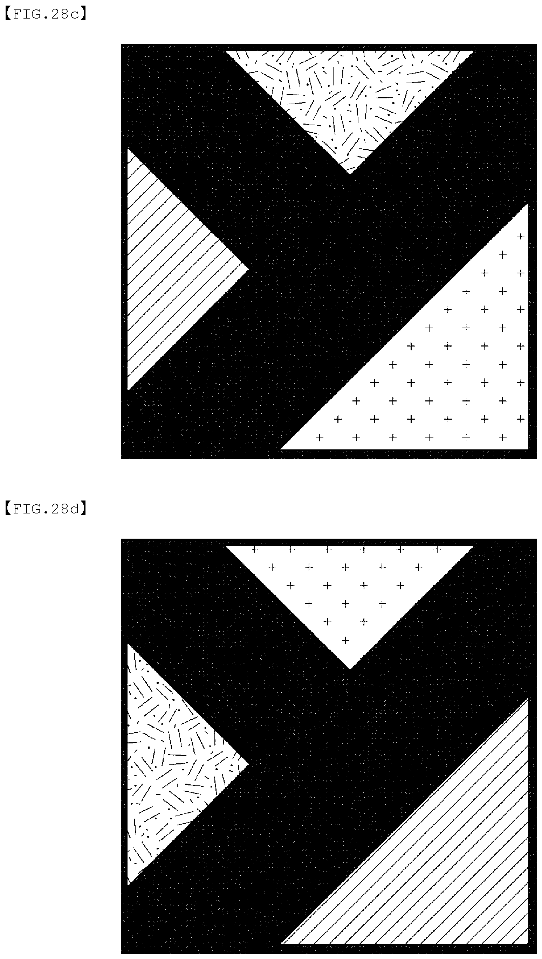

FIGS. 28a to 28d are modified forms of a pyramid pixel. In these drawings, the subpixel of each color may be positioned at each corner or side (e.g., may be positioned at one corner and two sides), and may have a triangle form. FIG. 28a shows a unit pixel. FIG. 28b shows pixels having a $2\times2$ array. FIGS. 28c and 28d show examples in which the arrangements of colors in FIG. 28a are different.

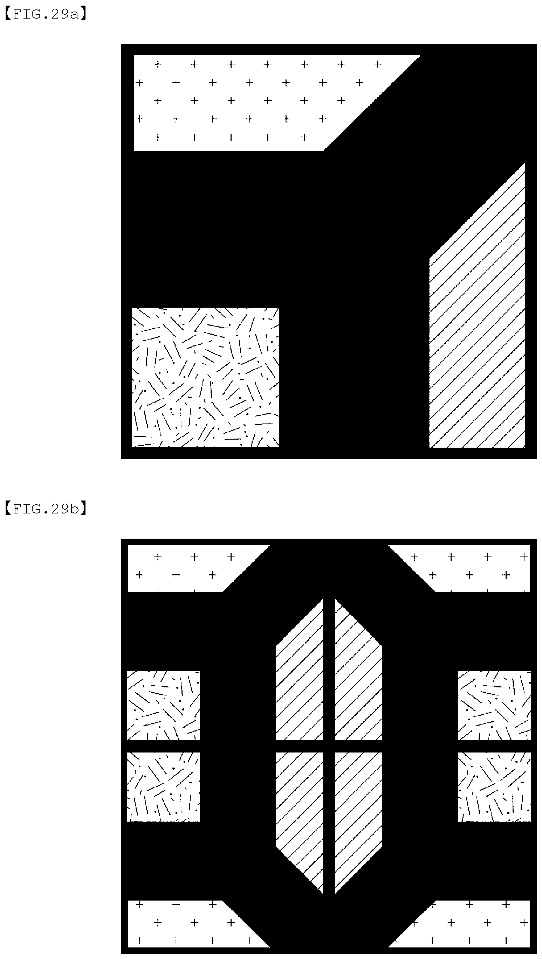

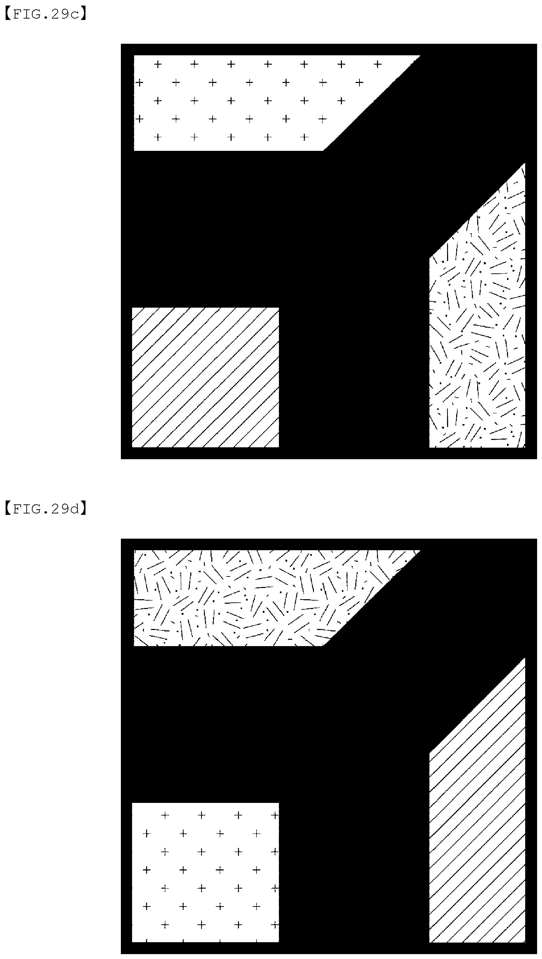

FIGS. 29a to 29d are modified forms of a pyramid pixel. In these drawings, the subpixel of each color may be positioned at each corner, and may have a square or trapezoid form. FIG. 29a shows a unit pixel. FIG. 29b shows pixels having a $2\times2$ array. FIGS. 29c and 29d show examples in which the arrangements of colors in FIG. 29a are different.

According to various embodiments of the present invention, a form of a figure and the size or ratio of a size used in a basic pixel or subpixel may be variously implemented. Furthermore, according to various embodiments of the present invention, many types of various embodiments may be possible by changing a relative location or size or a ratio thereof in positioning each subpixel within a unit pixel. Accordingly, various embodiments of the present invention are not limited to FIGS. 18 to 29.

The aforementioned display device (or display) may include, for example, a liquid crystal display (LCD), a light-emitting diode (LED) display, an organic light-emitting diode (OLED) display, a microelectromechanical systems (MEMS) display or an electronic paper display. The display may display, for example, various types of content (e.g., text, an image, video, an icon or a symbol) to a user. The display may include a touch screen, and may receive a touch, a gesture, proximity or a hovering input using an electron pen or part of the body of a user, for example.

The display device may be adopted in various types of electronic devices. Electronic devices to which the various embodiments of the present invention may be applied may include at least one of a smartphone, a tablet personal computer (PC), a mobile phone, a video telephone, an e-book reader, a desktop personal computer (PC), a laptop personal computer (PC), a netbook computer, a workstation, a server, a personal digital assistant (PDA), a portable multimedia player (PMP), an MP3 player, a mobile medical device, a camera, or a wearable device (e.g., smart glasses, a head-mounted device (HMD)), an electronic clothing, an electronic bracelet, an electronic necklace, an electronic accessory, an electronic tattoo, a smart mirror, or a smart watch), for example.

The present invention has been described above with an object of method steps indicating specific functions and performance of relations thereof. The boundaries and sequences of such functional elements and method steps have been randomly defined herein, for convenience of description. If the specific functions and relations are properly performed, alternative boundaries and sequences may be defined. Accordingly, such randomly alternative boundaries and sequences fall within the range and spirit of the claimed invention. Additionally, the boundaries of such functional elements have been randomly defined, for convenience of description. If any important functions are properly performed, alternative boundaries may be defined. Likewise, flowchart blocks may have been randomly defined in order to indicate any important function. For an extended use, flowchart block boundaries and sequences may have been defined, and perform any important functions. Alternative definitions of both the functional elements and flowchart blocks and sequences fall within the scope and spirit of the claimed present invention.

Furthermore, the present invention may have been described at least partially based on terms of one or more embodiments. The embodiments of the present invention are used herein in order to indicate the present invention, an aspect thereof, a characteristic thereof, a concept thereof and/or an example thereof. Physical embodiments of an apparatus, a thing of fabrication, a machine and/or a process that implement the present invention may include one or more aspect, characteristics, concepts, examples, etc. described with reference to one or more embodiments described herein. Furthermore, in all the drawings, the embodiments may integrate the identically or similarly named functions, steps, modules, etc., which may use the same or different reference numerals. As described above, the functions, steps, modules, etc. may be the same or similar functions, steps, modules, etc. or other things.

While the present invention has been described in conjunction with specific contents, such as detailed elements, limited embodiments, and the drawings, this has been provided to merely help general understanding of the present invention, and the present invention is not limited to the embodiments. A person having ordinary knowledge in the art to which the present invention pertains may change or modify the present invention in various ways based on the foregoing description.

Accordingly, the spirit of the present invention should not be determined based on only the described embodiments, and all changes equivalents to the claims and equivalent modifications thereof should be construed as belonging to the category of the spirit of the present invention.

[Description of reference numerals]

> 10: display panel 11: black region
> 100: display panel 110: data driving circuit
> 120: gate driving circuit 130: timing controller
> 300: unit pixel 310: first subpixel
> 320a, 320d: second subpixel 320b, 320c: third subpixel
> 330: isolated region 400a, 400b, 400c, 400d: unit pixel
> 410: isolated region 500: unit pixel
> 510: first subpixel 520a, 520d: second subpixel
> 520b, 520c: third subpixel 521b, 522c: second subpixel
> 521d, 522a: third subpixel 530: TFT back plane circuit
> 540: insulating material layer 550a, 550b, 550c, 550d, 550e: electrode
> 560a, 560b, 560c, 560d: PDL

**Claims**

1. A display device having a subpixel array structure, comprising:

    > a plurality of unit pixels each having a designated subpixel array structure,
    > wherein each of the unit pixels comprises at least one red subpixel, at least one green subpixel and at least one blue subpixel,
    > a first subpixel having a first color is positioned at a center of each of the unit pixels having a square form,
    > second subpixels having a second color are disposed at two corners diagonal to each other among four corners of each of the unit pixels, and
    > third subpixels having a third color are disposed at remaining two diagonal corners of the four corners.

2. The display device of claim 1, wherein the second subpixels and the third subpixels are isolated and disposed from a boundary between the unit pixels as much as a designated length.

3. The display device of claim 1, wherein at least one subpixel of a first unit pixel and at least one subpixel of a second unit pixel adjacent to the first unit pixel are merged to have a pyramid form.

4. The display device of claim 1, wherein subpixels adjacent to each other, among at least one subpixel of a first unit pixel and at least one subpixel of a second unit pixel adjacent to the first unit pixel, have the same color.

5. The display device of claim 1, wherein subpixels adjacent to each other, among at least one subpixel of a first unit pixel and at least one subpixel of a second unit pixel adjacent to the first unit pixel, are divided by an electrode.

6. The display device of claim 1, wherein the first subpixel is green.

7. The display device of claim 6, wherein the first subpixel has a diamond form.

8. The display device of claim 1, wherein:

    > the second subpixel is blue, and
    > the third subpixel is red.

9. The display device of claim 8, wherein the second subpixel or the third subpixel has a triangle form.

10. A display device having a subpixel array structure, comprising:

    > a plurality of unit pixels each having a designated subpixel array structure,

wherein each of the unit pixels comprises at least one red subpixel, at least one green subpixel and at least one blue subpixel,

first subpixels having a first color are disposed at two corners diagonal to each other among four corners of each of the unit pixels, and

a second subpixel having a second color and a third subpixel having a third color are disposed at remaining two diagonal corners of the four corners.

11. The display device of claim 10, wherein the subpixels disposed at the corners are isolated and disposed from a boundary between the unit pixels as much as a designated length.

12. The display device of claim 10, wherein subpixels adjacent to each other, among at least one subpixel of a first unit pixel and at least one subpixel of a second unit pixel adjacent to the first unit pixel, have the same color.

13. The display device of claim 10, wherein subpixels adjacent to each other, among at least one subpixel of a first unit pixel and at least one subpixel of a second unit pixel adjacent to the first unit pixel, are divided by an electrode.

14. The display device of claim 10, wherein the first subpixel is green.

15. The display device of claim 10, wherein each of the subpixels has a quadrangle form.

16. The display device of claim 10, wherein:

the second subpixel is blue, and
the third subpixel is red.

17. A display device having a subpixel array structure, comprising:

a plurality of unit pixels each having a designated subpixel array structure,
wherein each of the unit pixels comprises at least one red subpixel, at least one green subpixel and at least one blue subpixel,
a first subpixel having a first color is positioned at a first corner of four corners of each of the unit pixels, a second subpixel having a second color is positioned at a second corner of the four corners, and third subpixels having a third color are positioned at third corners of the four corners, and
each of the subpixels disposed at the corners is isolated and disposed from a boundary between the unit pixels as much as a designated length.

18. The display device of claim 17, wherein subpixels adjacent to each other, among at least one subpixel of a first unit pixel and at least one subpixel of a second unit pixel adjacent to the first unit pixel, have the same color.

19. The display device of claim 17, wherein subpixels adjacent to each other, among at least one subpixel of a first unit pixel and at least one subpixel of a second unit pixel adjacent to the first unit pixel, are divided by an electrode.

20. The display device of claim 17, wherein each of the subpixels has a triangle or quadrangle form.

【FIG.1】

【FIG.2】

【FIG.3】

【FIG.4】

【FIG.5】

【FIG.6a】

【FIG.6b】

【FIG.7a】

731a 740a 750a 731b 740b
PDL Electrode Electrode PDL
Insulating Layer 720
TFT Back-Plane Circuit 710

【FIG.7b】

732a 740c 750b 732b 740d
PDL Electrode Electrode PDL
Insulating Layer 720
TFT Back-Plane Circuit 710

【FIG.8a】

Super AMOLED Plus Pixel

【FIG.8b】

S-Stripe Pixel

【FIG.8c】

HoneyComb Pixel

【FIG.8d】

Diamond PenTile Pixel

【FIG.8e】

Pyramid Pixel - Type II

【FIG.8f】

Pyramid Pixel - Type IV

【FIG.8g】

Pyramid Pixel – Type V

【FIG.8h】

2×2 array –Type V

【FIG.9】

| | | | |
|---|---|---|---|
| R/G/B<br>[n-1, n-1] | R/G/B<br>[n-1, n] | R/G/B<br>[n-1, n+1] | |
| R/G/B<br>[n, n-1] | R/G/B<br>[n, n] | R/G/B<br>[n, n+1] | |
| R/G/B<br>[n+1, n-1] | R/G/B<br>[n+1, n] | R/G/B<br>[n+1, n+1] | |
| | | | |

【FIG.10】

【FIG.11】

【FIG.12】

【FIG.13a】

【FIG.13b】

【FIG.14】

Honey Comb

Zigzag width
42.3 µm

【FIG.15】

Diamond
PenTile

Zigzag width
63.5 µm

【FIG.16】

Pyramid
(Type II)

Zigzag width
49.2 µm

【FIG.17】

Pyramid
(Type IV)

Zigzag width
39.3 µm

【FIG.18a】

【FIG.18b】

【FIG.18c】

【FIG.18d】

【FIG.19a】

【FIG.19b】

【FIG.19c】

【FIG.19d】

【FIG.20a】

【FIG.20b】

【FIG.20c】

【FIG.20d】

【FIG.21a】

【FIG.21b】

【FIG.21c】

【FIG.21d】

【FIG.22a】

【FIG.22b】

【FIG.22c】

【FIG.22d】

【FIG.23a】

【FIG.23b】

【FIG.24a】

【FIG.24b】

【FIG.24c】

【FIG.24d】

【FIG.25a】

【FIG.25b】

【FIG.25c】

【FIG.25d】

【FIG.26a】

【FIG.26b】

【FIG.26c】

【FIG.27a】

【FIG.27b】

【FIG.27c】

【FIG.28a】

【FIG.28b】

【FIG.28c】

【FIG.28d】

【FIG.29a】

【FIG.29b】

【FIG.29c】

【FIG.29d】

## INTERNATIONAL SEARCH REPORT

| International application No. |
| --- |
| **PCT/KR2018/014754** |

| A. CLASSIFICATION OF SUBJECT MATTER |
| --- |
| *H01L 27/32(2006.01)i* |
| According to International Patent Classification (IPC) or to both national classification and IPC |

| B. FIELDS SEARCHED |
| --- |
| Minimum documentation searched (classification system followed by classification symbols) <br> H01L 27/32; G09G 3/30; G09G 3/32; G09G 3/3208; H01L 21/77; H01L 51/50 |
| Documentation searched other than minimum documentation to the extent that such documents are included in the fields searched <br> Korean Utility models and applications for Utility models: IPC as above <br> Japanese Utility models and applications for Utility models: IPC as above |
| Electronic data base consulted during the international search (name of data base and, where practicable, search terms used) <br> eKOMPASS (KIPO internal) & Keywords: sub-pixel, edge, center, opposite angle |

| C. DOCUMENTS CONSIDERED TO BE RELEVANT | | |
| --- | --- | --- |
| Category* | Citation of document, with indication, where appropriate, of the relevant passages | Relevant to claim No. |
| X <br> Y <br> A | KR 10-2013-0128714 A (SAMSUNG DISPLAY CO., LTD.) 27 November 2013 <br> See paragraphs [0054]-[0082] and figures 4-5. | 1-3 <br><br> 4-9 <br> 10-20 |
| Y | KR 10-2016-0148686 A (BOE TECHNOLOGY GROUP CO., LTD.) 26 December 2016 <br> See paragraphs [0097]-[0098] and figure 9. | 4,6-9 |
| Y | KR 10-2015-0109357 A (KATEEVA, INC.) 01 October 2015 <br> See paragraphs [0036]-[0098] and figures 2-11. | 5,13,19 |
| X <br> Y | US 2017-0053589 A1 (CHUNGHWA PICTURE TUBES, LTD.) 23 February 2017 <br> See paragraphs [0028]-[0051] and figures 1-7. | 10-12,14-18,20 <br><br> 13,19 |
| A | CN 106816449 A (KUNSHAN GOVISIONOX OPTOELECTRONICS CO., LTD.) <br> 09 June 2017 <br> See paragraphs [0028]-[0047] and figures 1-6. | 1-20 |

| ☐ Further documents are listed in the continuation of Box C. | ☒ See patent family annex. |
| --- | --- |

| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |
| --- | --- |
| Date of the actual completion of the international search <br><br> 03 APRIL 2019 (03.04.2019) | Date of mailing of the international search report <br><br> **03 APRIL 2019 (03.04.2019)** |
| Name and mailing address of the ISA/KR <br> Korean Intellectual Property Office <br> Government Complex Daejeon Building 4, 189, Cheongsa-ro, Seo-gu, Daejeon, 35208, Republic of Korea <br> Facsimile No. +82-42-481-8578 | Authorized officer <br><br><br> Telephone No. |

Form PCT/ISA/210 (second sheet) (January 2015)

INTERNATIONAL SEARCH REPORT
Information on patent family members

International application No.

**PCT/KR2018/014754**

| Patent document cited in search report | Publication date | Patent family member | Publication date |
|---|---|---|---|
| KR 10-2013-0128714 A | 27/11/2013 | US 2013-0307868 A1 | 21/11/2013 |
| | | US 2015-0340007 A1 | 26/11/2015 |
| | | US 9099025 B2 | 04/08/2015 |
| | | US 9966036 B2 | 08/05/2018 |
| KR 10-2016-0148686 A | 26/12/2016 | CN 104466007 A | 25/03/2015 |
| | | CN 104466007 B | 03/05/2017 |
| | | EP 3241237 A1 | 08/11/2017 |
| | | JP 2018-503848 A | 08/02/2018 |
| | | US 2016-0351116 A1 | 01/12/2016 |
| | | US 9959808 B2 | 01/05/2018 |
| | | WO 2016-107218 A1 | 07/07/2016 |
| KR 10-2015-0109357 A | 01/10/2015 | CN 104904015 A | 09/09/2015 |
| | | CN 104904015 B | 18/05/2018 |
| | | CN 105051932 A | 11/11/2015 |
| | | CN 108389887 A | 10/08/2018 |
| | | CN 108538889 A | 14/09/2018 |
| | | CN 108550708 A | 18/09/2018 |
| | | EP 2946405 A1 | 25/11/2015 |
| | | EP 2946423 A1 | 25/11/2015 |
| | | JP 2016-503231 A | 01/02/2016 |
| | | JP 2016-507131 A | 07/03/2016 |
| | | JP 2018-078128 A | 17/05/2018 |
| | | KR 10-1926225 B1 | 06/12/2018 |
| | | KR 10-2018-0125629 A | 23/11/2018 |
| | | KR 10-2018-0130015 A | 05/12/2018 |
| | | TW 201431050 A | 01/08/2014 |
| | | TW I622161 B | 21/04/2018 |
| | | US 2014-0197385 A1 | 17/07/2014 |
| | | US 2014-0197396 A1 | 17/07/2014 |
| | | US 2017-0236883 A1 | 17/08/2017 |
| | | US 2018-0315963 A1 | 01/11/2018 |
| | | US 9444050 B2 | 13/09/2016 |
| | | US 9614191 B2 | 04/04/2017 |
| | | WO 2014-113079 A1 | 24/07/2014 |
| | | WO 2014-113497 A1 | 24/07/2014 |
| US 2017-0053589 A1 | 23/02/2017 | CN 106469540 A | 01/03/2017 |
| | | US 10068522 B2 | 04/09/2018 |
| | | US 2017-0330510 A1 | 16/11/2017 |
| | | US 9761171 B2 | 12/09/2017 |
| CN 106816449 A | 09/06/2017 | NONE | |

Form PCT/ISA/210 (patent family annex) (January 2015)

50

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020160126567